# EUROPÄISCHE PATENTSCHRIFT

(11) **EP 1 568 071 B1**
(45) Veröffentlichungstag und Bekanntmachung des Hinweises auf die Patenterteilung: **20.03.2019**
(21) Anmeldenummer: 03799467.0
(22) Anmeldetag: 28.11.2003
(51) Int. Cl.: H01L 21/683

(54) **WAFER MIT TRENNSCHICHT UND TRÄGERSCHICHT UND DESSEN HERSTELLUNGSVERFAHREN**
WAFER COMPRISING A SEPARATION LAYER AND A SUPPORT LAYER AND ITS MANUFACTURING METHOD
TRANCHE COMPRENANT UNE COUCHE DE SEPARATION ET UN SUBSTRAT ET SON PROCEDE DE FABRICATION

(30) Priorität: 29.11.2002 DE 10256247; 14.11.2003 DE 10353530
(43) Veröffentlichungstag der Anmeldung: 31.08.2005
(73) Patentinhaber: Fraunhofer-Gesellschaft zur Förderung der angewandten Forschung e.V., 80686 München (DE); Nissan Chemical Corporation, Tokyo 103-6119 (JP)
(72) Erfinder: JAKOB, Andreas, 82319 Starnberg (DE); VISSING, Klaus-D., 27321 Morsum (DE); STENZEL, Volkmar, 27321 Thedinghausen (DE)
(74) Vertreter: Eisenführ Speiser
(86) Internationale Anmeldenummer: PCT/EP2003/013434
(87) Internationale Veröffentlichungsnummer: WO 2004/051708

(56) Entgegenhaltungen:
- EP-A- 0 252 739
- EP-A- 0 981 156
- WO-A-99/48137
- DE-A- 10 034 737
- FR-A- 2 823 012
- JP-A- H03 200 831
- US-A- 5 268 065
- US-A- 5 643 638
- US-A1- 2002 127 821
- PATENT ABSTRACTS OF JAPAN Bd. 1995, Nr. 07, 31. August 1995 (1995-08-31) -& JP 07 106285 A (OKI ELECTRIC IND CO LTD), 21. April 1995 (1995-04-21)
- PATENT ABSTRACTS OF JAPAN Bd. 018, Nr. 171 (E-1529), 23. März 1994 (1994-03-23) -& JP 05 343376 A (FUJITSU LTD), 24. Dezember 1993 (1993-12-24)
- PATENT ABSTRACTS OF JAPAN Bd. 2003, Nr. 02, 5. Februar 2003 (2003-02-05) -& JP 2002 316500 A (HORAISHA:KK), 29. Oktober 2002 (2002-10-29)
- PETASCH W ET AL: "Influence of plasma surface treatment on the adhesion of thin films on metals", SURFACE AND COATINGS TECHNOLOGY, ELSEVIER, AMSTERDAM, NL, vol. 59, no. 1-3, 1 October 1993 (1993-10-01), pages 301-305, XP025823802, ISSN: 0257-8972, DOI: 10.1016/0257-8972(93)90101-S [retrieved on 1993-10-01]
- HEGEMANN D ET AL: "Deposition of SiOx films from O2/HMDSO plasmas", SURFACE AND COATINGS TECHNOLOGY, ELSEVIER, AMSTERDAM, NL, vol. 116-119, 1 September 1999 (1999-09-01), pages 1033-1036, XP027346110, ISSN: 0257-8972 [retrieved on 1999-09-01]
- H Yasuda: "Glow Discharge Polymerization", Journal of Polymer Science: Macromolecular Reviews, 1 January 1981 (1981-01-01), pages 199-293, XP055256282, Retrieved from the Internet: URL:https://doi.org/10.1002/pol.1981.23016 0104ViewerXP [retrieved on 2016-03-08]
- MAGGIONI G ET AL: "Glow discharge vapour deposition polymerisation of polyimide thin coatings", SURFACE AND COATINGS TECHNOLOGY, ELSEVIER, AMSTERDAM, NL, vol. 142-144, 1 July 2001 (2001-07-01), pages 156-162, XP027329159, ISSN: 0257-8972 [retrieved on 2001-07-01]

## Beschreibung

### Anwendungsgebiet:

Ein erster (nicht erfindungsgemäßer) Aspekt des vorliegenden Textes betrifft Verfahren und Vorrichtungen zum Bearbeiten von Wafern. Sie sollen es erleichtern, die bei der Herstellung von Halbleiterprodukten verwendeten Wafer dünner zu fertigen. Dabei sollen die Wafer vorzugsweise sicherer zu bearbeiten sein und/oder der notwendige Fertigungsaufwand beim Herstellen von Halbleiterbauelementen und/oder Schaltungen und/oder Sensoren und/oder anderen Halbleiterprodukten reduziert und/oder kostengünstiger gestaltet und/oder der Einsatz von Laserstrahlschneidverfahren ermöglicht oder erleichtert und/oder - insbesondere - die Beschichtung und/oder Strukturierung der Rückseite des gedünnten Wafers ermöglicht oder erleichtert und/oder die Gefahr des Bruches und/oder der mechanischen Beschädigungen reduziert werden.

Ein weiterer, eng verwandter Aspekt betrifft Wafer mit einer Trennschicht und einer Trägerschicht (Deckschicht). Nachfolgend wird zunächst der erste Aspekt eingehend beschrieben, dann separat der zweite Aspekt (Erfindung gemäß Produktanspruch 1 und Verfahrensanspruch 11).

### Stand der Technik (erster Aspekt)

Die Verfahrensweise bei der Herstellung dünner Wafer und/oder dünner Halbleiterbauelemente weicht in der Regel von Anwender zu Anwender ab. Generell wird jedoch wie folgt verfahren. Bei der Herstellung von elektronischen Bauelementen und Schaltungen (Dioden, Transistoren, IC 's, Sensoren etc.) werden auf Wafern (Scheiben aus Silizium, GaAs oder anderen Halbleitermaterialen und Substraten) mittels verschiedener Technologien Bauelemente wie z. B. Strukturen, Schichten u.a. aufgebracht. Gegenwärtig werden diese Wafer nach Abschluss der hierzu notwendigen Fertigungsschritte auf der Vorderseite (aktive Seite, d.h. Seite auf der sich die aufgebrachten Bauelemente befinden) mit einer Schutzfolie oder einer sonstigen Schutzschicht (wie zum Beispiel eine mittels Wachs kontaktierte Glasplatte) versehen. Diese Folie bzw. Schicht hat die Aufgabe, die Wafervorderseite und somit die aufgebrachten elektrischen und mechanischen Strukturen während des anschließend folgenden Abdünnens des Wafers (durch Grinden, Läppen, Schleifen, Ätzen usw. der Rückseite) zu schützen. Nach Aufbringen der Folie oder Schicht wird der Wafer auf der rückwärtigen Seite abgedünnt. Dadurch wird die ursprüngliche Dicke des Wafers reduziert. Die verbleibende Restdicke wird nachhaltig von den zu erwartenden mechanischen Belastungen bei den nachfolgenden Prozessschritten bestimmt, die ohne signifikante Erhöhung der Bruchgefahr oder der Gefahr einer anderweitigen mechanischen Schädigung überstanden werden müssen. Nach dem Abdünnen kann sich zur Verbesserung der Brucheigenschaften des Wafers eine mechanische und/oder chemische Behandlung der Waferrückseite anschließen. Nach eventuellen Reinigungsschritten wird die Schutzfolie oder Trägerschicht von der Wafervorderseite abgezogen bzw. entfernt. Es können sich nun eventuelle weitere Fertigungsschritte und/oder Maßnahmen zur Verbesserung der mechanischen Eigenschaften und/oder Untersuchungen anschließen. Vielfach wird nun die Rückseite des gedünnten Wafers mit einer metallischen Schicht und/oder Schichten anderer Art überzogen und/oder strukturiert. Diese Beschichtung erfolgt meist mittels Sputtern, ähnlichen Abscheideverfahren im Vakuum und/oder lithografischen Verfahren und bedingt vielfach eine thermische Belastung und/oder thermische Unterstützung. Im Anschluss an die Rückseitenprozesse (Rückseitenbeschichtung und/oder Rückseitenstrukturierung) wird die vorderseitig schützende Folie oder der aufgebrachte Schichtverbund entfernt. Daran anschließend wird der Wafer vielfach mit der Rückseite nach unten (aktive Vorderseite nach oben) auf eine Sägefolie (Expansionsfolie bzw. Rahmen) aufgelegt. Abschließend erfolgt das Sägen des Wafers (Vereinzeln des Wafers zu separaten Bauteilen) mittels Rotationstrennscheiben oder anderer mechanischer Sägevorrichtungen. Vereinzelt kommen hierbei auch bereits Lasertrennverfahren zur Anwendung. Vereinzelt werden Wafer hierbei auch gebrochen, wobei vereinzelt unterstützende Verfahren des Ritzens zur Anwendung gelangen, oder der Wafer wird mittels Ätzverfahren vereinzelt. Mit den herkömmlichen Verfahren ist es sehr schwierig, dünne Wafer ohne erhöhte Bruchgefahr oder anderweitige Beschädigungen zu behandeln bzw. zu transportieren. Diese Schwierigkeiten ergeben sich u.a. aus dem Umstand, dass der Wafer nach dem Abdünnen in Relation zu seiner geringen Dicke zu hohen mechanischen Belastungen ausgesetzt werden muss. Diese Belastungen treten u.a. auf
a) während des Abziehens oder Ablösens (Enthaften) der Schutzfolie bzw. Schutzschicht, die während des Abdünnens die Wafervorderseite schützt,
b) während des Auflegens des Wafers auf die Sägefolie,
c) während des Transportes zwischen dem Abdünnen und dem Vereinzeln des Wafers (Trennen in Teile des Wafers, also in dies bzw. Mikroplättchen) und aller eventuell dazwischen geschalteten Fertigungsschritte. Insbesondere aber bei der Beschichtung der Rückseite.

Alternativ zu den aufgezeigten Verfahren werden heute schon Verfahren zur Anwendung gebracht und/oder entwickelt, bei denen der Wafer auf der Vorderseite (der strukturierten Seite) bereits vor dem Dünnungprozess mittels Schleifen von Ritzstrukturen und/oder Ritzen und/oder chemischen Ätzen und/ oder Plasmaätzen von Strukturen (dieser Begriff schließt insoweit auch Gräben ein) so strukturiert wird, dass diese Strukturen während des sich anschließenden Dünnungsprozesses mittels mechanischer und oder chemischer Verfahren freigelegt werden und somit eine Vereinzelung des Wafers stattfindet. Hierbei ist aber sehr oft nachteilig, dass die nunmehr vereinzelten Teile des Wafers (dies) nicht mehr wirtschaftlich während der nachfolgenden Prozessschritte gehandhabt werden können. Dieses begründet sich in der Tatsache, dass hierbei die Vielzahl bereits vereinzelter Bauelemente so fixiert sein muss, dass sich diese während der zu durchlaufenden Fertigungsschritte nicht ablösen und/oder ihre Position verändern.

### Nachteile des Standes der Technik (erster Aspekt)

Mit den gegenwärtig üblichen Verfahren ist es sehr schwierig und teilweise unmöglich, die gedünnten Wafer oder die bereits vereinzelten Teile des zuvor gedünnten Wafers (dies) auf der Waferrückseite wirtschaftlich zu beschichten. Insoweit dieses gegenwärtig geschieht, treten große Fertigungsverluste durch Waferbruch und/oder anderweitige Beschädigungen auf und/oder sind zu deren Vermeidung erhebliche manuelle Maßnahmen notwendig. Hierbei müssen zur Zeit die Wafer und/oder die vereinzelten Waferteile meistens sehr aufwendig und/oder sehr vorsichtig von Menschenhand und/oder durch aufwendige Vorrichtungen behandelt werden. Die Schwierigkeit ist hierbei insbesondere in der extrem dünnen Materialstärke des Wafers und/oder der Vielzahl der eventuell bereits vereinzelten Waferteile begründet.

### Aufgabe (erster Aspekt)

Dem ersten Aspekt liegt die Aufgabe zugrunde, ein Verfahren und eine Vorrichtung zum Bearbeiten eines Wafers anzugeben, das bzw. die es gestattet, den Fertigungsablauf nach dem Abdünnen des Wafers zu vereinfachen, wirtschaftlicher zu gestalten und das Behandeln von dünnen Wafern insbesondere bei der Rückseitenbeschichtung zu erleichtern. Weiterhin soll es ermöglicht werden, dass der Wafer während der Prozessschritte des Abdünnens, der Rückseitenbeschichtung und des Vereinzelns und aller Fertigungsschritte dazwischen, sicherer und wirtschaftlicher behandelt werden kann. Dabei soll insbesondere die Gefahr des Waferbruches vermindert werden.

### Lösung der Aufgabe (erster Aspekt)

Die gestellte Aufgabe wird gelöst durch ein Verfahren zum Bearbeiten eines Wafers, der auf einer Seite (Vorderseite) Bauelemente trägt, mit folgenden Schritten:
- Applizieren eines Schichtsystems auf der Vorderseite des Wafers, wobei das Schichtsystem zumindest eine die Vorderseite des Wafers kontaktierende Trennschicht und eine Trägerschicht umfasst,
- Abdünnen der Rückseite des Wafers, so dass das Schichtsystem den Wafer oder Teile des Wafers während des Abdünnens schützt oder trägt (hält).

Der Wafer, bei dem es sich auch um einen Wafer handeln kann, der auf der Wafervorderseite (der strukturierten Seite) bereits vor dem Dünnungprozess mittels Schleifen und/oder Ritzen und/oder chemischen Ätzen und/oder Plasmaätzen von Gräben und/oder anderen Strukturen so strukturiert wurde, dass diese Strukturen während eines sich anschließenden Dünnungsprozesses mittels mechanischer und/oder chemischer Verfahren (z.B. Ätzen) freigelegt werden und somit dabei eine Vereinzelung des Wafers stattfindet, wird vor dem Abdünnen (Materialabtrag auf der Rückseite) auf der Vorderseite mit einer Trennschicht überzogen. Diese Trennschicht wird hierbei vorzugsweise mittels CVD Verfahren aufgebracht. Bei dieser Trennschicht kann es sich beispielhaft um eine plasmapolymere Beschichtung handeln, wie sie am Fraunhofer Institut für Fertigungstechnik und Angewandte Materialforschung in Bremen entwickelt wurde. Es ist möglich, dass die Trennschicht in ihrer vollen Stärke durch den CVD Prozess und/oder durch einen anderen vakuumtechnischen Prozess erzielt wird und/oder durch (gegebenenfalls vorheriges) Auftragen eines geeigneten Materials unterstützt und/oder erzielt wird. Vorzugweise werden hierbei Trennschichtdicken von 1 bis 1000 nm bevorzugt 50 - 200 nm eingestellt. Die Schichtdicke kann aber auch kleiner oder größer sein. Die Haftungseigenschaften der Trennschicht lassen sich bei der mittels CVD Verfahren aufgebrachten plasmapolymeren Beschichtung durch prozesstechnische Anpassung auf beiden Seiten individuell einstellen. Die Trennschicht soll es einerseits erleichtern, eine sich hieran anschließende Schicht (Trägerschicht) später von der Waferoberfläche ablösen zu können. Sie soll aber auch eine ausreichende Bindungskraft (mittels Adhäsion und/oder anderen Bindungskräften) zwischen der Waferoberfläche und der sich anschließenden Trägerschicht für die nachfolgenden Prozessschritte aufweisen und/oder unterstützen und/oder ermöglichen. Diese Bindungskraft kann auch zum Teil aus der Eigenschaft der Oberflächentopographie der Waferoberfläche resultieren. Letzteres ist insbesondere dann von Bedeutung, wenn auftretende Scherkräfte kompensiert werden müssen, z. B. bei den mechanischen Verfahren des Abdünnens mittels Grinding oder anderer geeigneter Verfahren. Bestandteil des Wafers kann, so ist der Begriff Wafer im Rahmen dieses Textes zu verstehen, auch eine Passivierungsschicht an der Wafervorderseite sein, und zwar bevorzugt dann, wenn der Wafer elektronische Bauelemente umfasst. Eine solche Passivierungsschicht (soweit vorhanden) befindet sich bevorzugt direkt im Kontakt mit der Schicht des Wafers, die die elektronischen Bauelemente trägt.

Bevorzugt ist ein Verfahren mit folgendem zusätzlichen Schritt: Beschichten der abgedünnten Rückseite des Wafers, so dass das auf der Vorderseite angeordnete, gegebenenfalls strukturierte Schichtsystem den Wafer oder Teile des Wafers während des Beschichtens schützt oder trägt.

Besonders bevorzugt ist ein Verfahren mit folgender (zusätzlicher) Maßnahme: Vereinzeln des Wafers, wobei das (vorderseitige) Schichtsystem den Wafer oder Teile des Wafers während des Vereinzelns schützt oder trägt, wobei das Vereinzeln als separater Schritt durchgeführt oder durch das Abdünnen bewirkt wird und beim Vereinzeln das Schichtsystem durchtrennt oder nicht durchtrennt wird.

Unter Vereinzeln ist im Rahmen dieses Textes das Trennen des Wafers in Teile des Wafers (dies) zu verstehen.

Das Abdünnen kann beispielsweise chemisch (Ätzen) und/oder mechanisch erfolgen.

Bevorzugt ist ein Verfahren mit folgendem zusätzlichen Schritt: Glätten der Rückseite des Wafers, so dass sich die mechanischen Eigenschaften des Wafers ändern, vorzugsweise so, dass das Vereinzeln des Wafers bewirkt oder gefördert und/oder das Beschichten der abgedünnten Rückseite des Wafers gefördert wird. Das Glätten kann dabei durch chemisches oder physikalisches Ätzen (wie z. B. Plasmaätzen) oder mechanisches Polieren erfolgen und reduziert die Gefahr des Waferbruches.

Bevorzugt ist ein vorbeschriebenes Verfahren mit folgendem zusätzlichen Schritt vor Fertigstellung des Schichtsystems auf der Vorderseite des Wafers:
- (Vor-)Strukturieren des Wafers durch Schleifen und/oder Ritzen und/oder chemisches Ätzen und/oder physikalisches Ätzen, so dass sich die gebildeten Strukturen während des Abdünnens der Rückseite oder während einer anschließenden Bearbeitung der Rückseite öffnen und den Wafer vereinzeln.

Bevorzugt ist auch ein vorbeschriebenes Verfahren, in dem zum Vereinzeln des Wafers (a) ein Laserstrahl oder (b) ein mechanisches Verfahren, vorzugsweise Trennschleifen, Sägen oder Brechen, eingesetzt wird. Dabei wird insbesondere Variante (b) bevorzugt für nicht zur Trennung vorstrukturierte Wafer verwendet.

In einem weiteren bevorzugten Verfahren ist folgender Schritt nach dem Vereinzeln umfasst:
- Verringern der Haftung (a) des Schichtsystems an dem Wafer oder (b) der Trägerschicht an der waferseitig benachbarten Schicht des Schichtsystems, vorzugsweise der Trennschicht. Ziel dieser Vorgehensweise ist insbesondere, die Entnahme der vereinzelten Teile des Wafers mittels einer Vakuumvorrichtung oder einer anderen mechanischen Entnahmevorrichtung zu ermöglichen, wobei besonders bevorzugt kein sogenanntes Blue Tape auf der Rückseite des Wafers angebracht werden muss.

Vorzugsweise wird dabei das Verringern der Haftung im Falle (a) des Schichtsystems oder im Falle (b) der Trägerschicht erreicht durch (i) Bestrahlung mit elektromagnetischen Wellen, (ii) thermische Einwirkung, (iii) chemische Einwirkung und/oder (iv) mechanische Einwirkung. Die thermische Einwirkung kann dabei aus Erhitzen oder Abkühlen oder beiden Vorgängen bestehen.

Bevorzugt ist dabei ein Verfahren, in dem die Trennschicht mechanisch von der Trägerschicht oder dem Wafer oder den Teilen des Wafers enthaftet wird.

Bevorzugt ist auch ein Verfahren, in dem die Trennschicht des Schichtsystems vakuumtechnisch aufgebracht wird. Bei der Trennschicht handelt es sich bevorzugt um eine Schicht, wie sie in der DE 100 34 737 C2 beschrieben ist; es handelt sich vorzugsweise bei der Trennschicht um eine plasmapolymere Entformungsschicht, deren Eigenschaften so eingestellt sind, dass sie im Bereich der gewünschten Trennfläche (das ist die Fläche, entlang der die Trennung erfolgen soll) weniger fest an der angrenzenden Schicht haftet als sie an der anderen angrenzenden Schicht haftet. Diese Haftungseigenschaften können durch die Abstimmung der Trennschicht auf die an sie angrenzenden Schichten (also im Regelfall den Wafer und die Trägerschicht) erzielt werden. Bevorzugt geschieht dies durch Gestaltung der Trennschicht als plasmapolymere Gradientenschicht. Besonders bevorzugt ist dabei, dass die gewünschte Trennfläche entlang der Berührungsfläche von Trennschicht und Wafer verläuft, was bedeutet, dass die Trennschicht an dem Wafer weniger fest haftet als an der Trägerschicht.

Nach Aufbringen der Trennschicht wird eine weitere Schicht als Trägerschicht aufgebracht. Hierbei handelt es sich vorzugsweise um eine Kunststoffmasse (z.B. Polymer) die vorzugsweise mittels flüssigen Auftragens (z.B. per Spincoater) aufgebracht wird. Die Trägerschicht kann aber auch aus Photolack, Keramik, Metall, Kleber und/oder löslichen und/oder organischen und/oder anorganischen Substanzen und/oder einem Schichtverbund und/oder einer Mischung der vorgenannten Materialen bestehen.

In einer weiteren bevorzugten Ausgestaltung des Verfahrens wird die Trägerschicht mittels Wärme oder Bestrahlung mit Licht ausgehärtet.

Die Trägerschicht macht hierbei das Aufbringen einer sonst üblichen Folie überflüssig, wie sie nach den Verfahren aus dem Stand der Technik üblicherweise vor dem sich anschließenden Abdünnen (Grinding, Schleifen oder ähnlichen Verfahren zum Abdünnen von Wafern) auf der Vorderseite (strukturierten Seite) des Wafers zu dessen Schutz aufgebracht wird. Falls notwendig und/oder zweckmäßig kann die aufgebrachte Trägerschicht durch mechanisches Glätten und/oder Rotation wie z.B. Spincoating und/oder durch Anwendung anderer zweckmäßiger und/oder notweniger Verfahren eingeebnet und/oder geglättet werden. Die Schicht kann dabei und/oder anschließend durch thermische und/oder durch andere geeignete oder notwendige Verfahren z.B. UV- und/oder IR- Strahlung ausgehärtet und/oder verschmolzen werden.

Es kann vorteilhaft sein, die Eigenschaften des Schichtsystems und insbesondere der Trägerschicht mit dem Ziel einer späteren Vereinzelung des Wafers mittels Laser hinsichtlich ihrer Eigenschaften auf die Anwendung von Laserstrahlen hinsichtlich ihrer optischen oder sonstigen Materialeigenschaften abzustimmen. So soll eine Wechselwirkung des Schichtsystems und/oder dessen Veränderung oder Beschädigung während des Lasertrennens verhindert und/oder gemildert werden.

Das Schichtsystem kann (zum Zwecke der späteren Fixierung oder Halterung) Aussparungen und/oder Vorrichtungen und/oder mechanische Bestandteile (zum Fixieren oder Halten) besitzen und über die Fläche des Wafers hinausreichen.

Zur weiteren Verstärkung und/oder Unterstützung und/oder zur Erleichterung des sich anschließenden Handlings kann die Schicht mittels eines Trägers aus Glas, Metall und/oder anderen geeigneten organischen und/oder anorganischen Materialen und/oder einer Mischung der vorgenannten Materialien und/oder eines hieraus bestehenden Schichtverbundes unterstützt werden. Hierbei können auch Folien wie zum Beispiel Grinding- und/oder Schleiffolien zur Anwendung kommen.

Das aufgebrachte Schichtsystem (das zumindest die Trennschicht und die Trägerschicht umfasst) soll die Waferoberfläche während der sich anschließenden Prozesse, Handhabungen und Transporte tragen und/oder schützen und, falls notwendig, bereits vereinzelte Bauelemente (Waferteile) bis zur gewollten Entnahme und/oder deren Ablösen fixieren. Hierbei ist es möglich, insbesondere durch Abstimmung der Schicht- und Materialeigenschaften und/oder der Schichtdicke, die Schicht so abzustimmen, dass sie weitere Vorteile oder angepasste Eigenschaften aufweist. So können die Flexibilität, Adhäsion und/oder die Dämpfungseigenschaften der Schicht beeinflusst und eingestellt werden. Dabei kann es vorteilhaft sein, die Oberflächentopographie des Wafers gezielt einzubetten und somit zu schützen. Dies kann sich insbesondere bei bereits gebumpten Wafern als vorteilhaft erweisen, denn hierbei werden die hervorstehenden Kontakte mechanisch geschützt und somit wird beim sich anschließenden Abdünnen mittels Grinding und/oder Schleifen das meistens nicht erwünschte Durchdrücken der Kontakte vermindert oder ganz unterbunden.

Das aufgebrachte Schichtsytem hat mehrere Funktionen, wie sich zum Teil aus dem bereits Vorgesagten ergibt. Es schützt während des Abdünnens die Wafervorderseite mechanisch und/oder vor chemischer oder plasmatechnischer Beschädigung, vermindert die mechanischen Belastungen, die durch nachfolgendes Behandeln und Transportieren des Wafers entstehen, schützt die Wafervorderseite vor Verunreinigungen, dient als Sägefolie und soll insbesondere die Rückseitenbeschichtung vereinfachen. Hierbei ist es aber unerheblich, ob der Rückseitenbeschichtungsprozess vor oder nach dem Vereinzeln erfolgt oder ganz entfällt.

Vorteilhaft kann es sein, das Material der Trägerschicht so auszuwählen, dass es sehr geringe oder keine Reaktionen im Vakuum - zum Beispiel durch Ausgasen - zeigt. Für Beschichtungsprozesse ist es vorteilhaft, wenn das eingesetzte Trägerschicht-Material eine hohe Wärmleitfähigkeit aufweist und somit das gezielte Erwärmen des Wafers zulässt, oder die Wärme des Wafers gezielt abführt. Diese Eigenschaft kann beispielhaft durch das Zufügen geeigneter Füllstoffe erlangt werden. Weiterhin ist es häufig vorteilhaft, das Trägerschicht-Material so auszuwählen, dass es in seinem Verhalten bei Temperaturschwankungen an das Wafermaterial angepasst ist, z. B. indem Wafermaterial und Trägerschicht-Material so gewählt werden, dass sie sehr ähnliche Wärmeausdehnungskoeffizienten besitzen (Verhältnis Wärmeausdehnungskoeffizient Trägerschicht: Wärmeausdehnungskoeffizient Wafer liegt vorzugsweise im Bereich von 0,9 - 1,1).

Falls die Wafer ausreichend dünn sind, kann es vorteilhaft und/oder notwendig sein, diese mittels Laser und/oder anderer geeigneter mechanischer Verfahren wie z. B. Trennschleifen und/oder Sägen und/oder Ätzverfahren zu trennen. Hierbei wird der Wafer vorzugsweise mittels geeigneter optischer Verfahren (vorzugsweise im Spektrum des Infraroten Lichtes und zum Zwecke des Positionierens (Alignment - exaktes Ausrichten des Wafers, so dass mit größtmöglicher Genauigkeit die Bauelemente getrennt werden können)) so durchleuchtet, dass hierfür vorgesehene Strukturen und Markierungen (Sägebahnen) erkannt werden können. Nach dem Ausrichten des Wafers und/oder der Trenneinrichtung wird der Trennvorgang in Gang gesetzt. Hierbei fährt vorzugsweise ein Laser und/oder eine anders geartete Säge- und/oder Trenneinrichtung die zum Schneiden vorgesehenen Strukturen, Konturen und/oder Linien ab und schneidet (trennt), im Falle eines Lasers mittels seines Strahls. Dieser Vorgang wird durch geeignete Einrichtungen wie optische, elektrische oder mechanische Mess- und Regeleinrichtungen überwacht und gegebenenfalls nachgesteuert. Während oder nach dem Trennen des Wafers ist es vorgesehen und möglich, durch geeignete Einrichtungen die entstehenden Partikel, Gase und Stäube abzuführen, abzublasen, abzusaugen oder abzuwaschen. Es kann aber zum Zwecke des Trennens auch ein Ätzverfahren zur Anwendung gelangen.

Falls die gedünnte Waferrückseite einer Metallisierung und/oder Rückseitenstrukturierung unterzogen wird, kann es vorteilhaft sein, dieses noch vor dem Vereinzeln des Wafers durchzuführen. Auf diese Weise lassen sich Beschichtungen und/oder Beschädigungen an den andernfalls freiliegenden Trennkanten vermeiden. Zum Zwecke der Stabilisierung und/oder Unterstützung kann es vorteilhaft sein, den Wafer mitsamt der beschriebenen Trägerschicht durch eine weitere Schicht und/oder Träger zu halten oder zu fixieren.

Das Verfahren ermöglicht es zudem, den Wafer oder den Verbund von zu diesem Zeitpunkt bereits vereinzelten Teilen des Wafers zum Zwecke der Rückseitenbeschichtung in ein Vakuum zu prozessieren. So ist es insbesondere möglich, hierbei metallische Schichten im Vakuum mittels Sputtern, Bedampfen und/oder sonstigen geeigneten Verfahren aufzubringen. Hierbei sind bei der Beschichtung Temperaturen von über 300 °C möglich.

Bevorzugt ist ein Verfahren, in dem das Schichtsystem eine Schicht umfasst, die auf der von dem Wafer abgewandten Seite der Trägerschicht angeordnet ist und (a) die Form einer Folie besitzt oder (b) die Form einer Masse aus anorganischem und/oder organischem Material besitzt.

Nach Abschluss der vorgesehenen Bearbeitungsschritte kann es notwendig oder vorteilhaft sein, die aufgebrachte Trägerschicht wieder abzulösen. Vorzugweise wird hierbei auf die Rückseite des Wafers eine (weitere) Folie (z.B. Blue Tape) aufgebracht und anschließend die vorderseitig aufgebrachte Trägerschicht abgezogen. Beim Ablösen dieser Schicht kann es vorteilhaft sein, dass hierbei mechanische Vorrichtungen zur Anwendung kommen, die das Abziehen erleichtern. Insbesondere aber erleichtert die zwischen Waferoberfläche und Trägerschicht befindliche Trennschicht das Ablösen der Trägerschicht und/oder der vereinzelten Bauelemente. Hierbei ist es möglich, die individuellen Haftungseigenschaften beider Seiten der Trennschicht voneinander unabhängig so einzustellen, dass gezielt auf einer der beiden Seite der Trennschicht die Trennung erfolgt oder unterbunden wird. Bei der Trennung kann somit die Trennschicht entweder auf der Waferoberfläche verbleiben oder zusammen mit der Trägerschicht entfernt werden. Es kann alternativ aber auch zweckmäßig und/oder gewünscht sein, die vereinzelten Teile des Wafers direkt von der Trägerschicht abzuheben und/oder abzulösen. Zur Verminderung der Bindungskräfte oder Haftungseigenschaften der Trägerschicht kann es vorteilhaft und/oder erwünscht sein, die Bindungskräfte und/oder Hafteigenschaft mittels geeigneter Verfahren wie Bestrahlung mit UV- oder IR-Licht, thermischer Behandlung und/oder anderer geeigneter Verfahren zu reduzieren.

Bevorzugt ist ein Verfahren, wobei das Abdünnen der Rückseite des Wafers durch (i) Schleifen, (ii) Läppen, (iii) chemisches Nassätzen und/oder (iv) Plasmaätzen erfolgt. Das Schleifen kann dabei z. B. Grinden sein.

Besonders bevorzugt ist ein Verfahren mit folgenden Schritten:
a) Applizieren eines Schichtsystems auf der Vorderseite des Wafers, mit einer die Vorderseite des Wafers kontaktierenden Trennschicht und einer Trägerschicht
b) Aushärten und/oder Verfestigen der Trägerschicht
c) Abdünnen des Wafers auf seiner Rückseite
d) Glätten der Rückseite des Wafers, so dass sich die mechanischen Eigenschaften des Wafers ändern, vorzugsweise so, dass das Vereinzeln des Wafers bewirkt oder gefördert und/oder das Beschichten der abgedünnten Rückseite des Wafers gefördert wird
e) Beschichten der abgedünnten Rückseite des Wafers, wobei das Schichtsystem den Wafer und/oder Teile des Wafers während des Beschichtens schützt oder trägt,
f) Vereinzeln der Bauelemente des Wafers, wobei das Schichtsystem den Wafer und/oder Teile des Wafers während des Beschichtens schützt oder trägt und beim Vereinzeln das Schichtsystem nicht durchtrennt wird, und
g) bevorzugt mechanisches Enthaften der Trennschicht von der Trägerschicht oder dem Wafer oder den (bereits vereinzelten) Teilen des Wafers.

Besonders bevorzugt ist ein Verfahren bei dem das Schichtsystem so appliziert wird, dass die Trennschicht an der Vorderseite des Wafers haftet und an der Trägerschicht fester haftet als an dem Wafer.

Der erste Aspekt betrifft auch eine Vorrichtung zum Ausführen des entsprechenden Verfahrens. Vorzugsweise ist die Vorrichtung eine Anlage, ein Anlagesystem oder besteht aus miteinander verbundenen Anlagen. In der Vorrichtung sind bevorzugt Einrichtungen zum Aufbringen der Trennschicht, zum Aufbringen der Trägerschicht, zum Behandeln der aufgebrachten Schichten, zum Abdünnen und zum Vereinzeln von Bauelementen miteinander verbunden. Eine bevorzugte Vorrichtung zur Durchführung des Verfahrens umfasst:
- Mittel zum Applizieren eines Schichtsystems auf der Vorderseite eines Wafers, wobei das Schichtsystem zumindest eine die Vorderseite des Wafers kontaktierende Trennschicht und eine Trägerschicht umfasst und
- Mittel zum Abdünnen der Rückseite des auf der Vorderseite mit dem Schichtsystem versehenen Wafers, die so eingerichtet sind, dass das Schichtsystem den Wafer und/oder Teile des Wafers während des Beschichtens schützt oder trägt,
sowie gegebenenfalls:
- Mittel zum Beschichten der abgedünnten Rückseite des Wafers, die so eingerichtet sind, dass das Schichtsystem den Wafer und/oder Teile des Wafers während des Beschichtens schützt oder trägt und/oder
- Mittel zum Vereinzeln der Bauelemente des Wafers, die so eingerichtet sind, dass das Schichtsystem den Wafer und/oder Teile des Wafers während des Vereinzelns schützt oder trägt wobei
   das Vereinzeln als separater Schritt durchgeführt oder durch das Abdünnen bewirkt wird und
   beim Vereinzeln das Schichtsystem durchtrennt oder nicht durchtrennt wird und/oder
- Mittel zum Strukturieren des Wafers durch Schleifen und/oder Ritzen und/oder chemisches Ätzen und/oder physikalisches Ätzen, die mit anderen Bestandteilen der Vorrichtung so zusammenwirken, dass sich die gebildeten Strukturen während des Abdünnens der Rückseite oder während einer anschließenden Bearbeitung der Rückseite öffnen und den Wafer vereinzeln und/oder
- Mittel zum Verringern der Haftung (a) des applizierten Schichtsystems an dem Wafer oder (b) der Trägerschicht an der waferseitig benachbarten Schicht des Schichtsystems, vorzugsweise der Trennschicht und/oder
- Mittel zum Enthaften des Wafers oder von Teilen des Wafers von dem Schichtsystem.
Bevorzugte Bestandteile der Vorrichtung sind eine Beschichtungseinrichtung zum Aufbringen der Trennschicht und/oder der Trägerschicht (Schutz- oder Deckschicht) oder von Kombinationen von Schicht(en) und/oder Schichtsystemen auf die Vorderseite des Wafers, eine Einrichtung zum Aufbringen einer Rückseitenbeschichtung, eine Einrichtung zum Abdünnen des Wafers, eine Einrichtung zum Vereinzeln der Waferteile (dies), die aus einem Laser oder einer Laser-unterstützten Trennvorrichtung und/oder einer mechanischen Trennvorrichtung bestehen kann, eine Einrichtung zur Verringerung der Haftung der Trägerschicht auf der Vorderseite des Wafers (gegebenenfalls zusammen mit der Trennschicht) nach dem Vereinzeln und eine Einrichtung zum Ablösen der Bauelemente von der Schicht.

### Vorteile gemäß erstem Aspekt

Die Beschreibung gemäß erstem Aspekt ermöglicht die Realisierung wesentlicher technologischer Vorteile in der Fertigung und der Handhabung von Wafern bei der Herstellung von
elektrischen Bauelementen, IC's, Sensoren usw.. Mit dem Verfahren und der Vorrichtung wird die Fertigung vereinfacht und kostengünstiger gestaltet. Weiterhin können geringere Waferscheibendicken einfacher, wirtschaftlicher und sicherer realisiert werden.

Über die gegenwärtig in Anwendung befindlichen Trägerlösungen (Träger in Form von Folien oder anderen Schichtsystemen z. B. aus Glas in Verbindung mit Wachs) hinaus ergeben sich Vorteile insbesondere bei Verfahren zur Rückseitenbeschichtung von dünnen Wafern, insbesondere wenn diese Beschichtungen im Vakuum stattfinden und/oder unter thermischer Belastung erfolgen. Hierbei wird das Handling der dünnen Wafer oder der bereits vereinzelten Bauelemente dadurch vereinfacht, dass die aufgebrachte Trägerschicht den Wafer und/oder die vereinzelten Waferteile fixiert und/oder mechanisch unterstützt. Falls die Waferoberfläche ausreichende topografische Bedingungen besitzt, werden die vereinzelten Teile des Wafers auch hierdurch fixiert. Dieser Effekt kann auch erzielt und/oder unterstützt werden, wenn zum Zwecke der Vereinzelung eine vorderseitige Strukturierung der Waferoberfläche durchgeführt wurde. In die hierbei entstehenden Strukturen wird dann nämlich in der Folge sowohl die Trenn- wie auch die Trägerschicht eingebracht und eine mechanische Verankerung der nachfolgend vereinzelten Waferteile erzielt.

Ein weiterer Vorteil ist, dass ein (vorderseitig) aufgebrachtes Schichtsystem die Topographie der Waferoberfläche sehr gut und wohl besser als die derzeit in Anwendung befindlichen Folien schützen kann. Das nicht erwünschte Durchdrücken von Erhebungen auf der Waferoberfläche während der mechanischen Dünnungsverfahren kann deshalb vermindert oder sogar ausgeschlossen werden.

Ein weiterer Vorteil ist, dass das Schichtsystem mittels Vakuumverfahren und/oder Belackungsverfahren (z.B. Spincoating) aufgebracht werden kann. Somit können Verfahren zum Aufbringen und/oder Ablösen von Folien Trägermaterialien entfallen.

Im Weiteren können die vereinzelten Teile des Wafers aufgrund des (vorzugsweise nicht durchtrennten) Schichtsystems aus Trenn- und Trägerschicht als Verbund wie ein normaler monolithischer Wafer prozessiert und gehandhabt werden. Das Schichtsystem kann dabei auch die Funktion eines Transportmittel erfüllen und für das Shipment zwischen Hersteller und nachfolgendem Kunden und Anwender dienen.

Herausragende Bedeutung hat aber die erhöhte vakuumtechnische und thermische Verträglichkeit eines zu applizierenden Schichtsystems im Vergleich mit der Verwendung von Folien oder dergleichen.

### Beispiel 1

Nachfolgend wird davon ausgegangen, dass der Wafer bereits die Fertigungsschritte zum Aufbringen der Bauelemente, also insbesondere der elektrischen Bauelemente und/oder der mechanischen Strukturierung oder Schichten durchlaufen hat.

Die Wafervorderseite wird mittels eines CVD Verfahrens mit einer ca. 100 nm dicken plasmapolymeren Schicht überzogen, die in der Folge als Bestandteil eines Schichtsystems die aktive Oberfläche (Vorderseite) des Wafers bedeckt. Dabei besitzt sie beiderseitig individuell abgestimmte Adhäsionseigenschaften und dient als Trennschicht. Beispielsweise werden hierbei die Adhäsionseigenschaften so eingestellt, dass die Haftung der Trennschicht an der Wafervorderseite sehr gering und die Haftung der Trennschicht an der (in einem Folgeschritt zu applizierenden) Trägerschicht hoch ist; die Adhäsionseigenschaften können aber auch umgekehrt eingestellt werden.

Anschließend wird mittels Spincoating eine gegebenenfalls mit einem Füllstoff angereicherte Kunststoffmasse aus Polyamid als Trägerschicht aufgebracht und anschließend unter Verwendung von Wärme verfestigt.

Der Wafer wird nunmehr mittels Grinding von der Rückseite her gedünnt und anschließend zur Beseitigung von Oberflächenschäden chemisch geätzt. Der Wafer wird hiernach in einer Vakuumanlage mittels Sputtern auf der Rückseite mit Metall beschichtet. Hierbei erwärmt sich der Wafer auf ca. 350°C, ohne das dies das Schichtsystem zerstört. Abschließend wird der Wafer mittels eines optischen Verfahrens unter Verwendung von IR-Strahlung ausgerichtet und mittels eines Laserstrahls von der Rückseite her vereinzelt. Nach Abschluss der Vereinzelung wird die Rückseite mit einer Folie (Blue-Tape) überzogen und die Trägerschicht mitsamt der Trennschicht auf der Vorderseite abgezogen. Die vereinzelten Waferteile werden nunmehr mittels Pick und Place von der Folie entnommen und kontaktiert.

### Übersicht über bevorzugte Ausgestaltungen:

Weitere bevorzugte Ausgestaltungen des ersten Aspekts ergeben sich aus dem nachfolgenden Teil der Beschreibung und aus den zugehörigen Ansprüchen.

Bevorzugt ist ein Verfahren zum Behandeln von Wafern mit Bauelementen beim Abdünnen des Wafers und dem späteren Vereinzeln der Bauelemente und den gegebenenfalls dazwischen liegenden Fertigungsschritten, wobei die Vorderseite des Wafers mit den Bauelementen vor dem Abdünnen mit einer Schichtsystem überzogen wird, das zumindest aus einer Trennschicht und einer Trägerschicht besteht, wobei der Wafer und/oder die bereits vereinzelten Bauelemente durch das auf der Vorderseite aufgebrachte Schichtsystem während des Beschichtens der Waferrückseite geschützt werden und/oder von ihr gehalten werden.

Dem gegenüber bevorzugt ist das vorbeschriebene Verfahren, wobei zum Vereinzeln der Bauelemente ein Laserstrahl eingesetzt wird oder alternativ ein Verfahren, wobei zum Vereinzeln der Bauelemente ein mechanisches Verfahren wie Trennschleifen, Sägen und/oder Brechen zur Anwendung kommt.

Bevorzugt wird der Wafer in einem Verfahren durch das auf der Vorderseite des Wafers aufgebrachten Schichtsystems während des Abdünnens geschützt.

Bevorzugt wird der Wafer in einem Verfahren durch das auf der Vorderseite des Wafers aufgebrachte Schichtsystem während des Vereinzelns der Bauelemente geschützt.

Wiederum bevorzugt ist die Trennschicht in einem Verfahren eine vakuumtechnisch aufgebrachte Schicht, wobei nochmals bevorzugt die Trägerschicht aus einer Kunststoffmasse besteht und nochmals bevorzugt die Trägerschicht mittels Spincoater ausgebracht wird.

Bevorzugt ist ein Verfahren, wobei die Trägerschicht mittels Wärme ausgehärtet wird.

Bevorzugt ist ein Verfahren, wobei die Trägerschicht auch die Funktion eines Trägers übernimmt.

Bevorzugt ist ein Verfahren, wobei die Trägerschicht ein Schichtsystem aus mehreren Schichten ist.

Bevorzugt ist auch ein Verfahren, wobei zwischen dem Abdünnen des Wafers und dem Vereinzeln des Wafers auf der Rückseite des Wafers eine Reinigung und/oder chemische Behandlung zur Verbesserung der Brucheigenschaften des Wafers erfolgt.

Bevorzugt ist auch ein Verfahren, wobei zum Zwecke der Entnahme und /oder des Ablösens der Teile des Wafers die Haftung der Trägerschicht verringert wird.

Bevorzugt ist auch ein letztbeschriebenes Verfahren, wobei die Haftung der Trägerschicht durch Bestrahlung mit elektromagnetischen Wellen, durch Erwärmen, chemische Einwirkung und/oder durch mechanische Einwirkung verringert wird.

Bevorzugt ist auch ein Verfahren mit den Schritten:
a) Beschichten der Vorderseite des Wafers, in der die Bauelemente angeordnet sind, mit einer Trennschicht,
b) Beschichten einer Trägerschicht auf der Vorderseite des Wafers
c) Aushärten und/oder Verfestigen der Trägerschicht,
d) Abdünnen des Wafers von seiner Rückseite her auf eine gewünschte Dicke,
e) Behandlung der Waferrückseite mittels chemischer und/oder mechanischer Verfahren zum Zwecke der Verbesserung der mechanischen Eigenschaften und des gedünnten Wafers,
f) Beschichtung der Waferrückseite mit einer Schicht,
g) Vereinzeln des Wafers, wobei die Trägerschicht nicht durchtrennt wird.
h) Verringern der Haftung der Trägerschicht (4) an den Teilen des Wafers und

Bevorzugt können die Schritte e bis h in beliebiger Reihenfolge erfolgen und/oder einzelne oder sämtliche dieser Schritte entfallen.

Bevorzugt ist ein Verfahren, wobei der Wafer bereits vor dem Aufbringen der Trennschicht und/oder dem Aufbringen der Trägerschicht mittels Schleifen und/ oder Ritzen und/oder chemischer und/oder physikalischer Ätzverfahren so strukturiert ist, dass während des Abdünnens und/oder der sich anschließenden Rückseitenbearbeitung diese Strukturen sich öffnen und der Wafer somit vereinzelt ist.

Bevorzugt ist in manchen Fällen auch ein Verfahren, wobei der Trennprozess entfällt.

Bevorzugt erfolgt in einem Verfahren das Abdünnen durch Schleifen, Läppen, chemisches Nassätzen und/oder Plasmaätzen.

Bevorzugt ist ein Verfahren, wobei nach dem Aufbringen der Trägerschicht eine weitere Schicht in Form einer Folie aufgebracht wird und/oder wobei nach dem Aufbringen der Trägerschicht eine weitere Schicht in Form einer anorganischen und/oder organischen Masse aufgebracht wird.

Eine bevorzugte Vorrichtung zum Ausführen eines Verfahrens umfasst:
a) eine Beschichtungseinrichtung zum Aufbringen der Trennschicht,
b) eine Beschichtungseinrichtung zum Aufbringen der Trägerschicht,
c) eine Einrichtung zum Abdünnen des Wafers,
d) eine Einrichtung zum Vereinzeln der Bauelemente,
e) eine Einrichtung zum Beschichten der Waferrückseite
f) eine Einrichtung zum Verringern der Haftung der Trägerschicht an der Trennschicht
g) eine Einrichtung zum Ablösen der Bauelemente von der Trägerschicht.

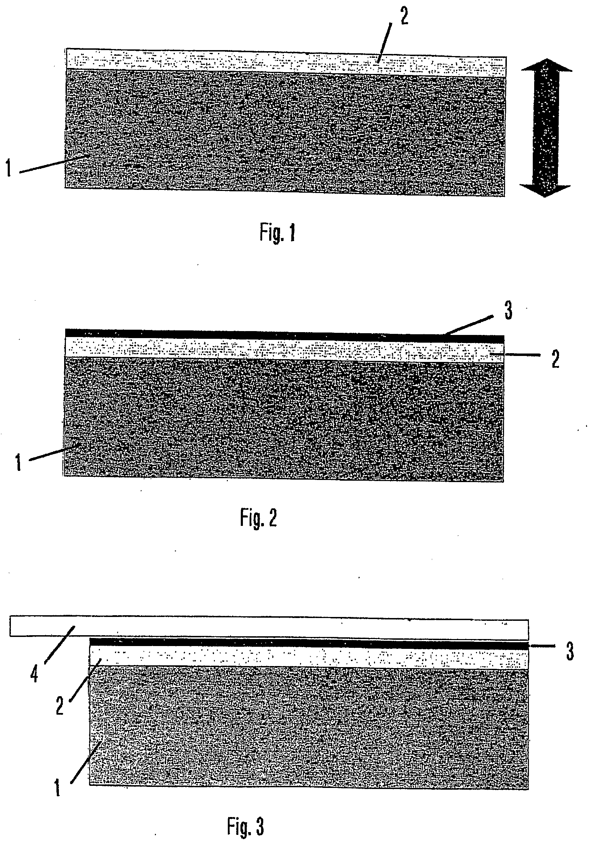

Im Folgenden wird der erste Aspekt dieses Textes anhand der Figuren 1 - 15 näher erläutert.

Die in den Figuren dargestellte Abfolge der Prozessschritte ist nur beispielhaft und kann von derzeitigen oder zukünftigen Verfahren abweichen. Insbesondere kann es vorteilhaft sein, den Wafer erst nach dem 12. Schritt (Rückseitenmetallisierung) mittels des 9. Schrittes (Lasertrennen) zu vereinzeln.

In den Figuren sind technische Angaben, Größenverhältnisse und Dimensionen nur beispielhaft.

Es zeigen bzw. verdeutlichen:
Fig.1: Schritt 1; schematisch dargestellt ist der Querschnitt eines Wafers(1, 2) mit einer abzudünnenden Zone 1 und elektronischen Bauelementen 2 und der ursprünglichen Dicke von z. B. 600 µm (Doppelpfeil).
Fig. 2: einen Wafer nach dem Schritt 2, d. h. dem Aufbringen einer Trennschicht 3 z.B. mittels CVD Beschichtungsverfahren.
Fig. 3: einen Wafer nach Schritt 3, dem Aufbringen einer Schutz- und Trägerschicht 4 durch Aufbringen einer Kunststoffmasse aus zum Beispiel Polymer (z. B. Polyamid). Hierbei kann es vorteilhaft sein die aufgebrachte Masse mittels geeigneter Verfahren wie zum Beispiel Spincoating zu verteilen und/oder einzuebnen.

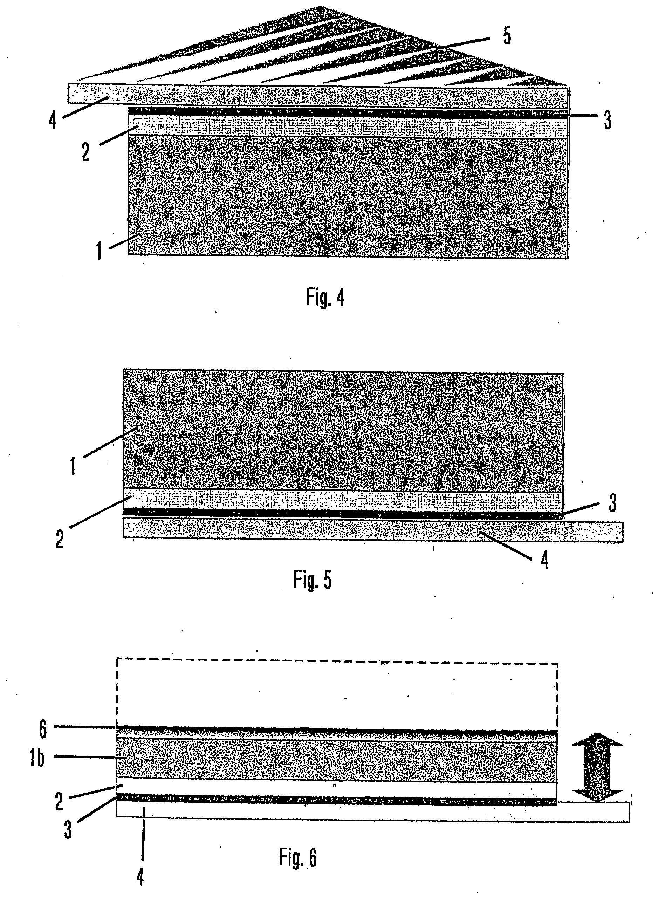

Fig.4: Schritt 4, das Aushärten und/oder Verfestigen der Schutz- und Trägerschicht durch thermische Behandlung (Erwärmen oder Erhitzen) und/oder durch eine andere geeignete chemische und/oder physikalische Behandlung 5 der Kunststoffmasse.
Fig. 5: einen in Schritt 5, dem Einbringen in eine mechanische Einrichtung zum mechanischen Abdünnen (Grinding und/oder Schleifen etc.) gedrehten Wafer.
Fig. 6: den Zustand nach Schritt 6 (Grinding/ Glätten); schematisch dargestellt ist der Querschnitt eines gedünnten Wafers 1b, 2 mit einer bereits abgedünnten Zone 1b. Auf der Rückseite befindet sich eine durch den Dünnungsvorgang beschädigte Zone 6. Die verbliebene Waferdicke von z. B. 100 µm ist durch einen Doppelpfeil gekennzeichnet, der erfolgte Abtrag der Waferrückseite durch gestrichelte Linien.

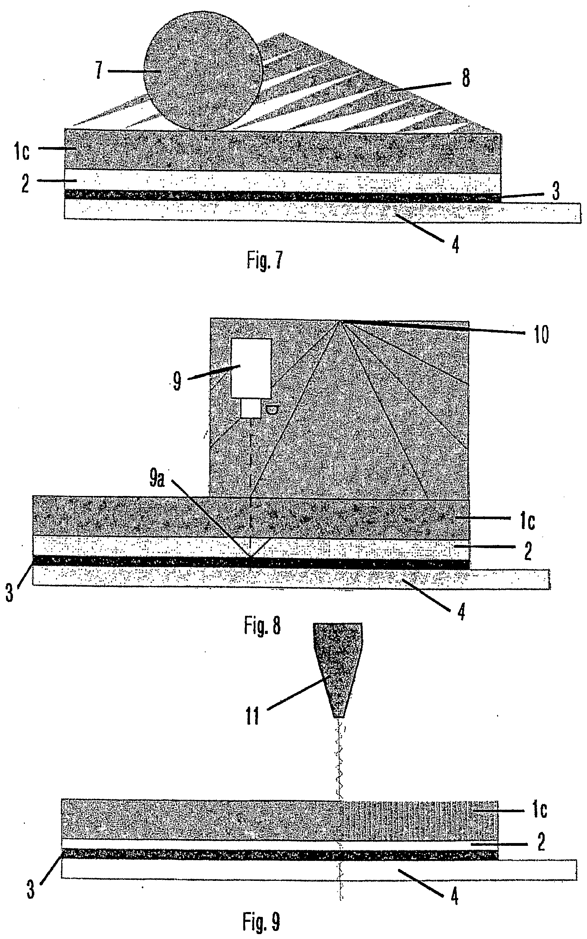

Fig. 7: Schritt 7; das Entfernen der beschädigten Zone 6 mittels mechanischer Verfahren wie zum Beispiel Polieren 7 und/oder durch chemische Verfahren wie zum Beispiel Ätzen 8 der Rückseite, so dass der Wafer 1c, 2 mit einer nochmals abgedünnten Zone 1c vorliegt.
Fig. 8: Schritt 8; das Ausrichten eines Wafers mittels optischer Verfahren. Insbesondere kann es hier vorteilhaft sein, den Wafer mittels Licht geeigneter Wellenlänge (zum Beispiel IR-Strahlung, IR-Strahlungsquelle 10) zu durchleuchten, um dadurch die auf der Vorderseite (aktive bzw. strukturierte Seite) des Wafers aufgebrachten Strukturen und/oder Markierungen 9a zum Zwecke der Positionierung des Wafers und/oder der Positionierung der Schneidevorrichtung (zum Beispiel des Lasers 11, vgl. Fig.9) mittels optischer Erfassungseinrichtungen (zum Beispiel IR-Kamera 9) zu erkennen.
Fig. 9: Schritt 9; das Trennen eines Wafers mittels geeigneter Schneidverfahren, hier mittels eines Laserschneidkopfes 11. Insbesondere kann es vorteilhaft sein, hierbei einen Laserstrahl mit/oder ohne Wasserstrahlunterstützung zu verwenden.

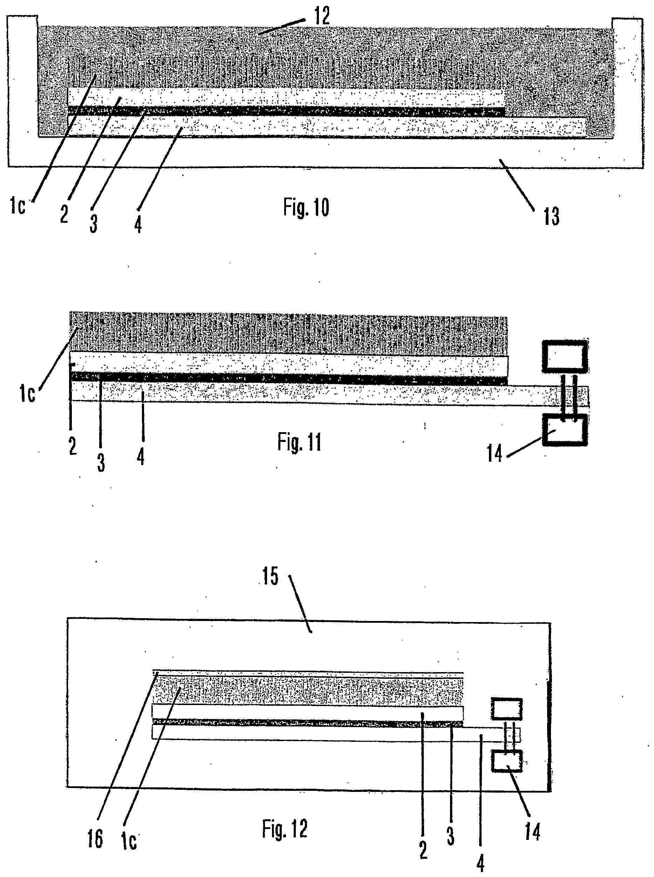

Fig. 10: Schritt 10; (bevorzugt, aber nicht obligatorisch), die Reinigung des Wafers. Zum Zwecke der Reinigung ist es vorteilhaft, den Wafer mittels geeigneter Verfahren zu reinigen. Insbesondere kann es vorteilhaft sein, hierbei flüssige Reinigungsmittel 12 wie z. B. Wasser mittels Aufsprühens und/oder Abspülens und/oder mittels eines Bades 13 anzuwenden. Es können aber alternativ oder ergänzend auch Verfahren wie Absaugen oder Abblasen zu Anwendung kommen.
Fig. 11: Schritt 11; das Fixieren des Wafers. Zum Zwecke einer besseren Fixierung und Halterung des Wafers kann es vorteilhaft und/oder notwendig sein den Wafer (z. B. über seine Trägerschicht 4) an einer Halterung 14 zu befestigen und/oder zu fixieren. Dies kann auch durch Verwendung eines weiteren Halters und/oder geeignete Verfahren wie Kleben, statische Aufladung oder ähnliche Verfahren erfolgen. Grundsätzlich ist die Möglichkeit der Fixierung und/oder Halterung für alle im Beispiel beschriebenen Fertigungsschritte vorgesehen, soweit dies vorteilhaft und/oder notwendig ist.
Fig. 12: Schritt 12; die Rückseitenbeschichtung. Zum Zwecke des Aufbringens einer Beschichtung auf der Rückseite des Wafers kann es vorteilhaft und/oder notwendig sein, diesen in ein Vakuum 15 zu verbringen. Die Beschichtung 16 auf der Rückseite kann hierbei aus einer metallischen Schicht bestehen, die mittels geeigneter Verfahren wir zum Beispiel Bedampfen und/oder Sputtern und/oder eines anderen geeigneten chemischen und/oder physikalischen Verfahrens angebracht wird.

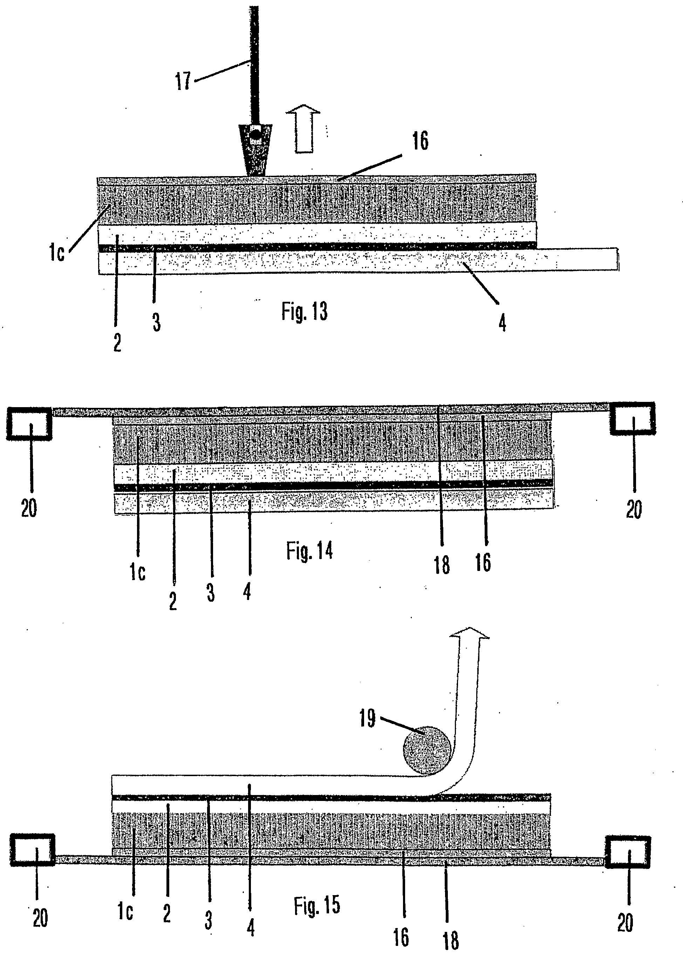

Fig. 13: Schritt 13; das Ablösen oder Abnehmen der vereinzelten Teile (Elemente) des Wafers mittels geeigneter Verfahren und oder Einrichtungen 17, z. B. einer Pick-Einrichtung. Hierbei kann es vorteilhaft und/oder notwendig sein, das Ablösen der Elemente durch geeignete chemische und/oder physikalische Verfahren zu unterstützen.
Fig. 14: eine Alternative zu Schritt 13: Es kann vorteilhaft und/oder notwendig sein, den Wafer mit der Rückseite auf eine andere Folie und/oder einen anderen Träger (zum Beispiel Trägerfolien wie Blue Tape) 18 abzulegen und/oder aufzukleben gegebenenfalls mittels Halterahmen 20 zu fixieren sowie den Wafer zu drehen.
Fig. 15: den Folgeschritt zur Alternative zu Schritt 13 gemäß Figur 14: In der weiteren Folge kann es notwendig und/oder vorteilhaft sein, die Trägerschicht abzuziehen. Hierbei kann es vorteilhaft sein, geeignete mechanische Verfahren und/oder Vorrichtungen (19) zur Anwendung zu bringen. Hierbei kann es vorteilhaft und/oder notwendig sein, das Ablösen der Trägerschicht durch geeignete chemische und/oder physikalische Verfahren zu unterstützen. Es kann (abhängig von den früheren Verfahrensschritten) beim Ablösen der Trägerschicht gezielt die Trennschicht vom Wafer mit entfernt werden (nicht zeichnerisch dargestellt) oder gezielt auf diesem belassen werden (zeichnerisch dargestellt).

### Beispiel 2

Bevorzugt ist, dass der abzudünnende und zu vereinzelnde Wafer innerhalb eines Fertigungsprozesses zur Herstellung von IC 's, Transistoren, Dioden, Sensoren usw. bereits die Mehrzahl der Fertigungsschritte zur Aufbringung der elektrischen und mechanischen Strukturen (Bauelemente) und Schichten durchlaufen hat. Der Wafer wird nun auf der Oberseite (der aktiven Seite, d.h. der Seite auf der sich die Strukturen befinden) mit einer Trennschicht und/oder einer Trägerschicht überzogen bzw. abgedeckt. Die Schicht und/oder der Schichtverbund mit dem darauf angeordneten Wafer wird auf einem Träger z.B. durch eine Folie fixiert und/oder durch eine Vakuumansaugeinrichtung gehaltert. Danach wird der Wafer in ein Anlagensystem eingeschleust. Danach findet der Bearbeitungsprozess zum Abdünnen des Wafers statt. Hierbei wird mittels der bekannten Verfahren wie zum Beispiel Schleifen, Läppen und/oder Ätzen die Dicke des Wafers verringert.

Der Wafer kann während oder im Anschluss an diesen Prozessschritt gereinigt werden. Weiterhin ist eine chemische Behandlung zum Zwecke der Verbesserung der Brucheigenschaften möglich. Nach Abschluss dieser Prozessschritte wird der Wafer innerhalb des Anlagensystems weitergetaktet und z.B. einer Trenneinrichtung zugeführt. Es ist anzumerken, dass eine oder auch mehrere Anlagenkomponenten zum Abdünnen und eine oder auch mehrere Anlagenkomponenten zum Trennen kombiniert werden können. Der Wafer wird der Trenneinrichtung zugeführt, ohne dass die auf der Vorderseite aufgebrachte Schicht oder das aufgebrachte Schichtsystem entfernt worden ist. Hierbei kann am Rand und/oder unter der Schicht oder dem Schichtsystem eine Einrichtung zum Transport und zum Zwecke des späteren Expandierens der Schicht oder des Schichtsystems angebracht sein.

Der Wafer wird nun mittels eines geeigneten optischen und/oder mechanischen Systems zur Trenneinrichtung hin ausgerichtet. Dabei kann vorzugsweise ein Verfahren mittels Infrarotdurch- oder -beleuctung zur Anwendung gelangen. Der Wafer liegt zu diesem Zeitpunkt immer noch mit seiner Vorderseite auf der Schicht oder dem Schichtsystem. Nach Ausrichten des Wafers wird nun der Wafer von der Rückseite her z.B. mit Hilfe eines Laserstrahls zersägt bzw. vereinzelt. Vorzugsweise wird der Laser durch einen sehr dünnen Wasserstrahl von etwa 25 µm Durchmesser geführt. Der Laserstrahl verläuft im inneren des Wasserstrahls und wird an der Innenwand des Wasserstrahls total reflektiert, so dass Streuverluste vermieden werden.

Es ist vorgesehen, dass z.B. die Schicht oder das Schichtsystem zum Abdecken der Wafervorderseite hinreichend porös ist, so dass der Wasserstrahl sie durchdringt, ohne sie zu beschädigen. Dabei bleiben die Schicht und/oder das Schichtsystem intakt und die vereinzelten Bauelemente auf der Folie behalten ihre Position. Es kann aber auch eine mechanische Einrichtung zum Trennen wie zum Beispiel zum Trennschleifen und/oder Sägen und/oder Brechen zur Anwendung kommen.

Nachfolgend kann sich innerhalb des Anlagensystems oder auch außerhalb ein Reinigungsprozess anschließen. Das Anlagensystem kann auch eine Anlage oder Vorrichtung zum Zwecke der mechanischen und/oder chemischen Beschichtung der Waferrückseite beinhalten. Hierbei sind insbesondere vakuumtechnische Verfahren und Anlagen betroffen, mittels derer insbesondere metallische Schichten mittels zum Beispiel Sputtern und/oder Bedampfen und/oder anderer Verfahren aufgebracht werden. Hierbei ist vorgesehen, dass die Rückseitenbeschichtung vor und/oder nach dem Trennvorgang erfolgen kann. Weiterhin kann das Anlagensystem um eine Komponente zum Entnehmen der nun vereinzelten elektrischen Bauelemente erweitert werden. Es ist auch vorgesehen, dass der zertrennte Wafer mit Träger und Lackschicht oder Folie oder ohne Schicht in einem Kassettensystem abgelegt werden kann.

Bei der Ablage ohne Trägerschicht ist eine Einrichtung zum Abtrennen von der Trägerschicht in dem Anlagesystem vorgesehen. Vorzugweise besteht die Trennschicht aus einer mittels CVD-Verfahren aufgebrachten Nitridschicht. Es können aber ausdrücklich auch andere Schichten (nicht erfindungsgemäß) und/oder Schichtsysteme (nicht erfindungsgemäß) zur Anwendung kommen. Vorzugsweise besteht die Trägerschicht aus einem Kunststoff mit guten Adhäsionseigenschaften. Die Verbindung der Trägerschicht mit dem Wafer erfolgt vorzugsweise durch Adhäsion der Trennschicht. Wird die Verbindung der Trägerschicht mit dem Wafer im wesentlichen durch Adhäsion bewirkt, kann eine Ablösung durch Erwärmen mittels Bestrahlung mit elektromagnetischen Wellen (z.B. IR oder UV) oder durch Wärmeinleitung erreicht werden.

Der zweite Aspekt dieses Textes (Erfindung) ist mit dem ersten Aspekt technisch eng verwandt; er wird jedoch aufgrund seiner hohen wirtschaftlichen Bedeutung separat diskutiert.

Der zweite Aspekt (Erfindung) betrifft einen Wafer mit einer Trägerschicht (Deckschicht) und einer zwischen der Trägerschicht und dem Wafer angeordneten Trennschicht, ein Verfahren zur Herstellung eines solchen Wafers, ein Verfahren zum Abdünnen eines Wafers und ein Verfahren zum Rückseitenmetallisieren eines Wafers.

### Stand der Technik/Ausgangslage (zweiter Aspekt, Erfindung)

Häufig besteht die technische Notwendigkeit, Oberflächen temporär abzudecken, um sie für einen Transport oder nächste Verarbeitungsschritte zu schützen. Eine weitverbreitete Methode besteht z.B. darin, Teile von Autos mit einer Klebfolie abzudecken, um die Lackierung auf dem Transport zum Kunden zu schützen oder Fahrzeuge vorübergehend mit Werbeaufdrucken zu versehen. Weiterhin finden temporäre Abdeckfolien in der Lackierung (Reparaturlackierung) weite Verbreitung, um Bereiche um Reparaturstellen abzudecken.

Bei der Herstellung von Halbleiterbauteilen (dies (dices)) auf Wafern werden heute ebenfalls vielfach Klebefolien (z.B. sogenannte Grindingfolien oder Blue Tapes) zur temporären Abdeckung verwendet, um das Handling für die Rückseitenbearbeitung bzw. das Trennen (Vereinzeln durch Schneiden) einfacher gestalten zu können und außerdem insbesondere die Wafervorderseite, auf der sich die eigentlichen elektronischen Bauelemente befinden, zu schützen.

Die Entwicklung im Bereich der Halbleiterfertigung bewegt sich derzeit in eine Richtung, die darauf abzielt, den Siliziumwafer und damit den Träger der eigentlichen elektronischen Bauelemente und Schaltungen nach dessen Herstellung sehr stark zu abzudünnen. Dabei können heute Dicken von weniger als 40 - 50 µm erreicht werden. Die vielfältigen Vorteile, die ein solches Vorgehen mit sich bringt, sollen, obwohl sie sehr weitreichend sind, hier nicht näher dargestellt werden. Als Beispiel sei jedoch angeführt, dass bei geringer Dicke des Wafers - und damit auch der daraus herausgetrennten Mikroplättchen (Die) - das unerwünschte Übersprechen (Cross-talking) zwischen den elektronischen Bauelementen innerhalb des Mikroplättchens sowie das Substratrauschen beispielsweise mit Hilfe einer Rückseitenmetallisierung wirkungsvoll verringert werden kann. Dieser Effekt beruht unter anderem darauf, dass mit abnehmender Dicke der Siliziumschicht auch der Eigenwiderstand der Siliziumschicht abnimmt. Zudem besitzt ein dünner Wafer eine höhere Wärmeleitfähigkeit als ein dicker Wafer, was für den späteren Einsatz gewünscht ist.

### Nachteile des Standes der Technik (zweiter Aspekt, Erfindung)

Aus der geringen Dicke entstehen jedoch nicht nur Vorteile, sondern es entstehen auch Schwierigkeiten, insbesondere bei der weiteren Verarbeitung der Wafer: Ein stark gedünnter Wafer wird zunehmend labil bzw. verbiegt sich durch Spannung in der Funktionsbeschichtung. Außerdem besitzt er nur noch eine sehr geringe Wärmekapazität. Dadurch entstehen für die nachfolgenden Bearbeitungsschritte große Schwierigkeiten und Herausforderungen. Dies betrifft insbesondere die Rückseitenmetallisierung, bei der Temperaturen von etwa 370 bis 380 °C aufgewendet werden müssen und zusätzlich eine Vakuumverträglichkeit des zu beschichtenden Wafers zu gewährleisten ist. Die stark verringerte Masse und damit die ebenfalls stark verringerte Wärmekapazität des Wafers führt dazu, dass die elektrischen Schaltungen erheblich stärker durch die hohen Metallisierungstemperaturen belastet werden.

Darüber hinaus stellt das Handling sehr stark gedünnter Wafer in den üblichen hochautomatisierten Prozessen eine Herausforderung aus dem Gesichtspunkt der mechanischen Belastung und der Weiterverarbeitbarkeit in vorhandenen Handlingseinrichtungen dar.

Es gibt bislang keine in industriellem Maßstab verwirklichte und zufriedenstellende Lösung, um einen stark gedünnten Wafer mit einer Rückseitenmetallisierung versehen zu können, da alle Formen von bislang bekannten Trägerfolien aufgrund der benötigten hohen Metallisierungstemperatur versagen.

Als zu beschichtende Oberflächen kommen aus heutiger Sicht hauptsächlich Waferoberflächen zum Einsatz, die mit einer Schutzschicht aus Siliziumnitrid und/oder Siliziumoxid bzw. Polyimid versehen sind. Grundsätzlich sind aber auch andere Werkstoffe nicht ausgeschlossen. Außerdem sind die Oberflächen in der Regel durch elektrische Schaltungen oder zusätzlich durch ein "Dicing"-Verfahren strukturiert, durch welches die Wafer für die Trennung in einzelne Dies vorbereitet wurden.

Aus dem Stand der Technik sind Verfahren zur Bearbeitung eines Wafers bekannt, bei denen insbesondere die Wafervorderseite zeitweise zum Schutz und/oder zum vereinfachten Handling abgedeckt wird. So offenbart die DE 100 29 035 C1 ein Verfahren zur Bearbeitung eines Wafers, bei dem ein sogenannten Trägerwafer auf den zu bearbeitenden Wafer aufgebracht wird. Die beiden Wafer werden mittels einer Verbindungsschicht verbunden, die teilweise in Löcher des Trägerwafers eingebracht wird und so auf den durch die Löcher freiliegenden Teilen des zu bearbeitenden Wafers aufliegt. Nach Durchführen von Bearbeitungsschritten an der Rückseite des zu bearbeitenden Wafers wird der Trägerwafer durch Entfernen der Verbindungsschicht wieder abgetrennt.

Die US 5,981,391 offenbart ein Verfahren zur Herstellung einer Halbleitervorrichtung, das das Schützen der Vorderseite eines Wafers durch ein adhäsives Medium umfasst, sowie das Entfernen dieses adhäsiven Mediums nach Bearbeiten der Rückseite des Wafers und das Erwärmen des Wafers nach dem Entfernen des adhäsiven Mediums auf eine Temperatur, die höher ist als die thermische Zersetzungstemperatur des Adhäsivs, das durch das adhäsive Medium zur Verfügung gestellt wurde.

Die WO 99/08322 offenbart einen beschichteten Wafer, wobei die Beschichtung immer zumindest Titan umfasst.

Die WO 99/48137 offenbart ebenfalls einen mit einer Schicht versehenen Wafer, bei dem die Schicht die Vorderseite des Wafers bei nachfolgenden Bearbeitungsschritten schützen soll. Ein solcher Gegenstand wird auch in der DE 198 11 115 A1 offenbart, wobei in beiden Dokumenten die Schicht zumindest bis nach dem Vereinzeln des Wafers in Dies auf dem Wafer verbleibt.

Die US 6,263,566 B1 offenbart ebenfalls einen Wafer mit einer Beschichtung, von der ausgewählte Bereiche nach Bearbeitungsschritten wieder entfernt werden können.

Auch die US 2002/0127821 A1 beschreibt einen Wafer mit einem Schichtsystem, wobei eine polymere Trennschicht offenbart ist.

Die im Stand der Technik offenbarten Beschichtungen sind allesamt noch nicht optimal und lassen sich z.B. nur teilweise oder unter hohem Aufwand wieder vom Wafer trennen. Darüber hinaus ist das Aufbringen der Schichten häufig umständlich und das Schichtmaterial nicht optimal an seine Aufgaben angepasst.

### Aufgabe der Erfindung (zweiter Aspekt, Erfindung)

Aufgabe der vorliegenden Erfindung war es, die genannten Nachteile des Standes der Technik zu überwinden. Gelöst wird diese Aufgabe durch einen Wafer mit einer Trägerschicht und einer zwischen der Trägerschicht und dem Wafer angeordneten Trennschicht, wobei die Trennschicht eine plasmapolymere Schicht ist, die an dem Wafer haftet und an der Trägerschicht fester haftet als an dem Wafer. Dabei werden Verfahren (PECVD bzw. Plasmapolymerisation für die Trennschicht und vorzugsweise Spin-Coating für den Auftrag der Trägerschicht) angewendet, die in der Halbleiterindustrie üblich sind, so dass keine besonderen Umstände entstehen.

Als Trägerschicht für den Wafer kann eine Vielzahl von Materialien eingesetzt werden, und zwar bevorzugt solche, die einerseits flexibel sind, andererseits aber über eine ausreichende mechanische Härte verfügen, um eine Schutzfunktion ausüben zu können. Ein Beispiel sind Schichten aus Polyimid, die zusätzlich noch die Möglichkeit eröffnen, die Schicht auf einfache Weise auf den Wafer aufzutragen und sie erst nachträglich (beispielsweise thermisch) zu härten. Polyimid bietet sich auch deshalb an, weil es für die Rückseitenmetallisierung ausreichend temperaturbeständig ist.

Bei der Trennschicht handelt es sich gemäß der Erfindung um eine Plasmapolymerschicht, wobei die Ausführungsform des Verfahrens, mit dem diese Trennschicht aufgetragen wurde, nicht entscheidend ist, solange die Zusammensetzung der Trennschicht und das Auftragverfahren so gewählt ist, dass die Haftung der Trennschicht an der Trägerschicht höher ist als die an der Oberfläche des Wafers. Von Gleichspannungs- bis Mikrowellenanregung ist alles möglich. Auch die Verwendung von Atmosphärendruckplasmen ist nicht ausgeschlossen.

Die Herstellung der plasmapolymeren Trennschicht erfolgt allerdings bevorzugt im Niederdruckplasmapolymerisationsverfahren. Bei dieser Vorgehensweise kommt der Gaszusammensetzung bei Start des Plasmabeschichtungsprozesses eine besondere Bedeutung zu: Ein zu hoher Restsauerstoffgehalt oder eine zu hohe Restfeuchte (z.B. aus Wandbelegungen) führen zu einer starken, unkontrollierten Veränderung der Gaszusammensetzung und damit zu einer nicht optimalen ersten Monolage der Beschichtung, welche jedoch die Haftungseigenschaften reproduzierbar herstellen muss. Eine nicht optimale erste Monolage der Beschichtung kann auch dann eintreten, wenn diese Lage während der Einschwingphase des Plasmas abgeschieden wird. Daher ist es bevorzugt, gezielt die notwendigen Rahmenbedingungen für das Abscheiden der ersten Monolage herzustellen. Dieses kann beispielsweise durch ausreichendes Evakuieren (zwei bis drei Zehnerpotenzen unterhalb des späteren Arbeitsdruckes) ggf. unterstützt durch ein Ausfrieren von Feuchtigkeit und/oder Ausheizen der Plasmakammer geschehen. Und/oder auch insbesondere während der Einschwingphase des Plasmas durch temporäres Abdecken des zu beschichtenden Wafers im Vakuum (z.B. durch eine bewegliche Blende) erfolgen. Nach der Einschwingphase herrschen ausreichend stabile Verhältnisse, da der Restsauerstoffgehalt bzw. die Restfeuchte im Reaktor durch den Plasmaprozess stark reduziert wird. Die Hafteigenschaften der Trennschicht zum Wafer werden nach Bedarf über die Veränderung der Reaktionsparameter, beispielsweise Gaszusammensetzung, Leistung und/oder Druck hergestellt. Die Dicke der Trennschicht beträgt vorzugsweise 1 bis 1000 nm, weiter bevorzugt 10 bis 500 nm und besonders bevorzugt 50 bis 200 nm.

Bevorzugt besteht der Wafer des erfindungsgemäßen Gegenstands (Wafer mit Trägerschicht und Trennschicht) aus gegebenenfalls dotiertem Silizium und umfasst wiederum bevorzugt vorderseitig eine aktive Schicht mit elektronischen Bauelementen, wobei die Trennschicht auf der Vorderseite angeordnet ist. Wie oben angedeutet umfasst der Wafer, wenn er eine aktive Schicht mit elektronischen Bauelementen umfasst, regelmäßig auch eine Passivierungsschicht, die beispielsweise aus Siliziumnitrid und/oder Siliziumoxid bzw. Polyimid bestehen kann. Auf dieser Passivierungsschicht (als Bestandteil des Wafers) wird in diesem Fall die oben beschriebene Trennschicht angeordnet. Die Vorderseite des Wafers wird durch die Lage der aktiven Schicht mit elektronischen Bauelementen definiert: Die Seite, auf der die aktive Schicht des Wafers angeordnet ist, wird als Wafervorderseite bezeichnet.

Bevorzugt ist ein erfindungsgemäßer Wafer (Wafer mit Trenn- und Trägerschicht), bei dem die Trennschicht eine Gradientenschicht ist und/oder eine an die Trägerschicht angrenzende Adhäsivzone und eine an den Wafer angrenzende Dehäsivzone sowie gegebenenfalls eine Übergangszone umfasst, wobei die Adhäsiv- und die Dehäsivzone stofflich unterschiedlich zusammengesetzt sind. Eine Dehäsivzone ist dabei die Zone, die an dem Substrat (ohne Wafer) schlechter anhaftet als die "Adhäsivzone" an ihrem zugehörigen Substrat (der Trägerschicht).

Im Rahmen des Abscheidungsprozesses der plasmapolymeren Trennschicht ist es möglich, die Abscheidungsparameter z.B. über die Gaszusammensetzung so zu steuern, dass die Trennschicht eine Adhäsiv- und eine Dehäsivzone umfasst. Dies ist insbesondere dann sinnvoll, wenn die Schicht des Wafers (z.B. eine Passivierungsschicht), welche die Trennschicht tragen soll oder trägt, ähnliche oder gleiche Adhäsionseigenschaften wie die zur Anwendung kommende Trägerschicht besitzt. Durch die entsprechende Wahl der Abscheidungsparameter ist es möglich, die Adhäsionseigenschaften der Adhäsiv- und der Dehäsivzone gegenüber den an die Trennschicht angrenzenden Schichten (Trägerschicht und tragende Schicht des Wafers) genau einzustellen.

Eine mittels Niederdruckplasmapolymerisation hergestellte Trennschicht ist aus der DE 100 34 737 C2 bekannt. Dort wird allerdings eine plasmapolymere Trennschicht beschrieben, die sich (anders als die Trennschicht des erfindungsgemäßen Wafers) dadurch auszeichnet, dass sie eine hervorragende Haftung zum metallischen Substrat (also zu der Schicht auf die sie aufgetragen wurde) aufweist, wobei schrittweise während des Abscheidungsprozesses zu dehäsiven Eigenschaften übergegangen wird. Eine solche Trennschicht wird typischerweise zur Beschichtung metallischer Formen in der Kunststoffverarbeitung verwendet, um auf flüssige Trennmittel verzichten zu können. Die auf diese Schicht aufgebrachten Kunststoffe lassen sich bei entsprechender Anpassung der Trennschicht rückstandsfrei den Formen entnehmen.

Überraschenderweise lässt sich mittels eines Abscheidungsprozesses, der genau umgekehrt zu dem in der DE 100 34 737 C2 beschriebenen Verfahren geführt wird, eine Trennschicht erhalten, die in der Waferbearbeitung eingesetzt werden kann. Die Abscheidebedingungen für die plasmapolmere Trennschicht müssen also im Unterschied zum Verfahren gemäß DE 100 34 737 C2 so gewählt werden, dass letztere mit ihrer Dehäsivzone zuerst abgeschieden wird. Damit wird gewährleistet, dass nach Auftrag einer Trägerschicht (auf die zuletzt abgeschiedene Adhäsivzone der Trennschicht) die Trennung zwischen Dehäsivzone und Wafer erfolgen kann.

Bevorzugt ist ein erfindungsgemäßer Gegenstand (Wafer mit Trägerschicht und Trennschicht) besonders in einer der beschriebenen bevorzugten Ausgestaltungsformen, bei dem die Trennschicht waferseitig mit einem zunächst flüssigen Precursor hergestellt wird, der später integraler Bestandteil der Gesamtbeschichtung wird.

Eine besonders gute Qualität für die Dehäsiveigenschaften der Trennschicht lässt sich dadurch erreichen, dass der zu beschichtende Wafer vor dem Einbringen in die Vakuumkammer (beim Niederdruckplasma) dünn mit einem flüssigen Precursor benetzt wird, an den folgende Anforderungen gestellt werden:
- Er sollte im Vakuum nicht zu wesentlichen Teilen verdampfen.
- Er sollte eine trennaktive Substanz sein (z.B. ein Silikonöl wie AK5 bis AK50 der Firma Wacker Chemie).

Der Fachmann wird den flüssigen Precursor vorzugsweise an die Chemie der plasmapolymeren Trennschicht anpassen, und der Precursor sollte bevorzugt so dünn aufgetragen werden (z.B. 0,1 bis 50 nm), dass der Precursor durch den anschließenden Plasmaprozess Teil der plasmapolymeren Beschichtung wird. Besonders bevorzugt ist dabei, dass der zunächst flüssige Precursor vollständig in die Trennschicht integriert wird. Der flüssige Precursor wird auf das Substrat (den Wafer) bevorzugt durch Tauchen, Sprühen oder Spin-Coating aufgebracht, eine Beschichtung der Waferrückseite (das ist die der Vorderseite gegenüberliegende Seite des Wafers) sollte vermieden werden.

Der so aufgebrachte flüssige Precursor wird im ersten Schritt der Plasmapolymerisation den aktiven Bestandteilen des Plasmas (Elektronen, Protonen, Ionen etc.) ausgesetzt. Dadurch findet üblicherweise sowohl eine Vernetzung der Precursor-Moleküle untereinander (bevorzugt zur Polymerkette bzw. zu einem dreidimensionalen Polymergerüst) statt als auch eine mit derjenigen Schicht, die aus der Gasphase abgeschieden wird. Der zunächst flüssige Precursor wird also zum integralen Bestandteil der plasmapolymeren Transferbeschichtung und kann damit auch anschließend mit dieser vom Wafer wieder entfernt werden.

Der Fachmann wird die Art des flüssigen Precursors und die Beschichtungsdicke (auf dem Substrat), sowie die nachfolgenden Schritte der plasmapolymeren Beschichtung so aufeinander abstimmen, dass eine weitgehende Integration, bevorzugt eine vollständige Integration des zunächst flüssigen Precursors in die plasmapolymere Beschichtung erfolgt. Dies ist nach Entfernung der Trennschicht vom Wafer z.B. mit Kontaktwinkelmessung der Wafervorderseite überprüfbar. Auch mit XPS (X-ray photoelectron spectroscopy) lassen sich gegebenenfalls Precursorrückstände auf der Vorderseite des Wafers nachweisen.

Durch das Einsetzen eines solchen flüssigen Precursors kann außerdem gegebenenfalls die Gesamtbeschichtungszeit im Plasma reduziert werden.

Bevorzugt ist ein erfindungsgemäßer Gegenstand (Wafer mit Trennschicht und Trägerschicht), bei dem die Trennschicht an dem Wafer und an der Trägerschicht bei Temperaturen bis zumindest 350 °C, bevorzugt bis zumindest 380 °C, besonders bevorzugt bis zumindest 400 °C weitgehend unverändert haftet. Eine hohe Temperaturbeständigkeit ist besonders dann von Bedeutung, wenn im Rahmen der Weiterbearbeitung des Wafers Schritte geplant werden, die mit einer erhöhten Temperaturbelastung der Schicht einhergehen (z.B. Rückseitenmetallisierung).

Wurde ein flüssiger Precursor eingesetzt, verliert dieser durch die oben beschriebene Vernetzung seine Eigenschaft als flüssiges Trennmittel. Er wird integraler. Teil der Plasmapolymerbeschichtung. Dadurch erlangt auch er eine entsprechende Temperaturstabilität.

Bevorzugt ist ein erfindungsgemäßer Gegenstand, bei dem sich die Trennschicht im Wesentlichen rückstandsfrei vom Wafer lösen lässt. Besonders bevorzugt ist ein solcher erfindungsgemäßer Gegenstand, bei dem sich die Trennschicht vollständig rückstandsfrei ablösen lässt. Da mit der Trennschicht auch die Trägerschicht vom Wafer abgelöst wird, ist es möglich, eine Vielzahl von Weiterverarbeitungsschritten mit einem erfindungsgemäßen Wafer (Wafer mit Trennschicht und Trägerschicht) durchzuführen (z.B. Rückseitenmetallisierung, Abdünnen, Vereinzeln in Dies), wobei der Wafer durch die Trägerschicht (und gegebenenfalls auch durch die Trennschicht) geschützt ist. Durch eine entsprechende Ausgestaltung in der Trägerschicht ist es darüber hinaus auch möglich, den Wafer an eine geplante maschinelle Weiterverarbeitung anzupassen. Durch ein möglichst rückstandsfreies Ablösen von Trenn- und Trägerschicht (besonders wichtig in den Bereichen, in denen die Kontaktierung elektronischer Bauteile erfolgen soll) können nach dem Vereinzeln die einzelnen Dies (Mikroplättchen) ohne die störende Trägerschicht ihrer Bestimmung zugeführt werden.

Bevorzugt ist dabei ein erfindungsgemäßer Wafer, bei dem die Trennschicht und der Wafer mechanisch enthaftbar sind (z.B. durch ein Schälverfahren).

Nach den Verarbeitungsschritten ist im Regelfall der Wafer (bzw. die aus ihm hergestellten Mikroplättchen) extrem empfindlich. Deswegen kann es erwünscht sein, den Wafer nicht chemischem oder thermischem Stress zu unterwerfen. Da die Adhäsionsstärken der Trennschicht (wie oben beschrieben) gezielt beeinflussbar sind, können diese so eingestellt werden, dass die für das mechanische Enthaften benötigte mechanische Belastung für den Wafer bzw. die Mikroplättchen nicht mehr zu hoch ist. Durch ein geeignetes Verfahren kann auch gleichzeitig mit der Enthaftung das Auftrennen des Wafers in die einzelnen Mikroplättchen erfolgen (z.B. wenn in einem vorhergehenden Schritt der Wafer weit genug gedünnt wurde, nachdem zuvor schon Vertiefungen entlang der geplanten Trennlinie in den Wafer eingebracht wurden, z.B. durch Sägen oder unter Verwendung eines Lasers).

Bevorzugt ist ein erfindungsgemäßer Gegenstand, bei dem die Trägerschicht aus einem polymeren Material besteht. An dieses Material werden in der Regel besondere Anforderungen gestellt: Hierzu gehört eine ausreichende Temperaturstabilität für die nachfolgenden Prozesse, vorzugsweise bis 400 °C. Weiterhin sollte das Material vorzugsweise mit Hilfe eines Spin-coating Verfahrens auftragbar sein und über eine möglichst hohe Wärmeleitfähigkeit bzw. Wärmekapazität verfügen. Darüber hinaus sollen die Eigenspannungen sehr gering bzw. an die des gedünnten Wafers angepasst sein, um ein Verbiegen zu verhindern, denn nur ein ebener Wafer lässt sich in den vorhandenen Einrichtungen fehlerfrei bearbeiten. Die Schichtdicke der Trägerschicht sollte vorzugsweise so einstellbar sein, dass die Dicke ausgeglichen wird, die durch das Abdünnen des Wafers entfernt worden ist. Falls keine ausreichende Ebenheit der Trägerschicht durch das Auftragungsverfahren erreichbar ist, so ist zusätzlich noch ein Schleif- bzw. Polierverfahren anzuwenden, um diesen Ansprüchen zu genügen.

Bevorzugt ist ein erfindungsgemäßer Gegenstand, bei dem die auf ihm angeordnete Trennschicht eine Wärmeleitfähigkeit besitzt, die die des Wafers um maximal 10 % unterschreitet.

Vorteilhaft ist eine hohe Wärmeleitfähigkeit der Trennschicht, da insbesondere bei einer Rückseitenmetallisierung der Wafer, gerade wenn er zu einem hohen Maße gedünnt worden ist, so großem thermischen Stress ausgesetzt wird, dass Teile der elektronischen Bauelemente in der aktiven Schicht zerstört werden können, falls eine entsprechende Wärme(ab)leitung nicht gewährleistet ist. Besitzt die Trennschicht und idealerweise auch die Trägerschicht entsprechende Wärmeleiteigenschaften (und besonders bevorzugt eine hohe Wärmekapazität) so ist eine Verringerung des thermischen Stresses innerhalb der aktiven Zone gewährleistet.

Die Anwendung der Beschichtung (Trägerschicht mit Trennschicht) kann auch auf der Rückseite erfolgen, wenn sich hieraus Vorteile, wie z.B. beim Handling oder der Weiterverarbeitung, ergeben.

Teil der Erfindung ist auch ein Verfahren zur Herstellung eines Wafers mit einer Trägerschicht und einer zwischen der Trägerschicht und dem Wafer angeordneten Trennschicht, umfassend die Schritte:
a) Bereitstellen eines Wafers,
b) Versehen des Wafers mit einer plasmapolymeren Trennschicht, so dass diese an dem Wafer haftet,
c) Aufbringen einer Trägerschicht auf die Trennschicht, so dass die Trennschicht an der Trägerschicht fester haftet als an dem Wafer,
wobei der Wafer bevorzugt vorderseitig eine aktive Schicht mit elektronischen Bauelementen umfasst und die Trennschicht an der Vorderseite angeordnet wird.

Bevorzugt ist dabei, dass im Schritt b) die Trennschicht auf den Wafer abgeschieden wird, wobei die Abscheidungsbedingungen zeitlich variiert werden, so dass die erzeugte Trennschicht eine Gradientenschicht ist und/oder eine Adhäsivzone zum Aufbringen der Trägerschicht und eine an den Wafer angrenzende Dehäsivzone sowie gegebenenfalls eine Übergangszone umfasst. Bevorzugt wird dabei der Wafer vor dem Schritt b) mit einem flüssigen Precursor benetzt, der wiederum vorzugsweise eine trennaktive Substanz ist, um so die Trenneigenschaften der Dehäsivzone der Trennschicht in gewünschter Weise zu beeinflussen. Bevorzugt wird im erfindungsgemäßen Verfahren, dass der flüssige Precursor mittels Tauchens, Sprühens oder eines Spin-Coating-Verfahrens auf den Wafer aufgebracht wird. Ganz besonders bevorzugt wird das erfindungsgemäße Verfahren im Schritt b) so durchgeführt, dass der flüssige Precursor vernetzt und integraler Bestandteil der Trennschicht wird.

Teil der Erfindung ist auch ein Verfahren zum Abdünnen eines Wafers, umfassend die folgenden Schritte:
- Herstellen eines Wafers mit einer Trägerschicht und einer zwischen der Trägerschicht und dem Wafer angeordneten Trennschicht nach einem vorbeschriebenen erfindungsgemäßen Verfahren (bevorzugt nach einem für den zweiten Aspekt der Erfindung beschriebenen Verfahren), wobei in Schritt a) ein zu abdünnender Wafer bereitgestellt wird und
- Abdünnen des Wafers von seiner Rückseite her, sowie ein Verfahren zum Rückseitenmetallisieren eines Wafers, umfassend die folgenden Schritte:
   - Herstellen und gegebenenfalls Abdünnen eines Wafers mit einer Trägerschicht und einer zwischen der Trägerschicht und dem Wafer angeordneten Trennschicht nach einem vorbeschriebenen erfindungsgemäßen Verfahren (bevorzugt nach einem für den zweiten Aspekt der Erfindung beschriebenen Verfahren) und
   - Aufbringen einer Metallschicht auf die Rückseite des Wafers.

Hinsichtlich der bevorzugten Ausgestaltungen gilt das jeweils zuvor Gesagte.

Die beiden letztgenannten erfindungsgemäßen Verfahren sind gegenüber entsprechenden Verfahren aus dem Stand der Technik vereinfacht, und zwar insbesondere wegen der Kombination des Wafers mit der (wiederablösbaren) Trägerschicht und durch die Eigenschaften (z.B. Wärmeleitfähigkeit) der Trennschicht.

Bevorzugt werden bei den zwei letztgenannten erfindungsgemäßen Verfahren die Trenn- und die Trägerschicht nach dem Abdünnen und/oder dem Rückseitenmetallisieren wieder von dem Wafer entfernt.

Bevorzugt sind erfindungsgemäße Verfahren (bevorzugt nach einem für den zweiten Aspekt der Erfindung beschriebenen Verfahren), bei denen ein zur Trennung in einzelne Elemente vorbereiteter Wafer eingesetzt wird, wobei wiederum bevorzugt eine Trennung des Wafers - gegebenenfalls mit Ausnahme der Rückseitenmetallisierung - in einzelne Elemente, durch das Abdünnen oder das Entfernen der Trenn- und der Trägerschicht erfolgt. Hierbei ist zu beachten, dass Unterschneidungen auf der Waferoberfläche dem Abtrennprozess hinderlich sind und daher vorzugsweise vermieden werden.

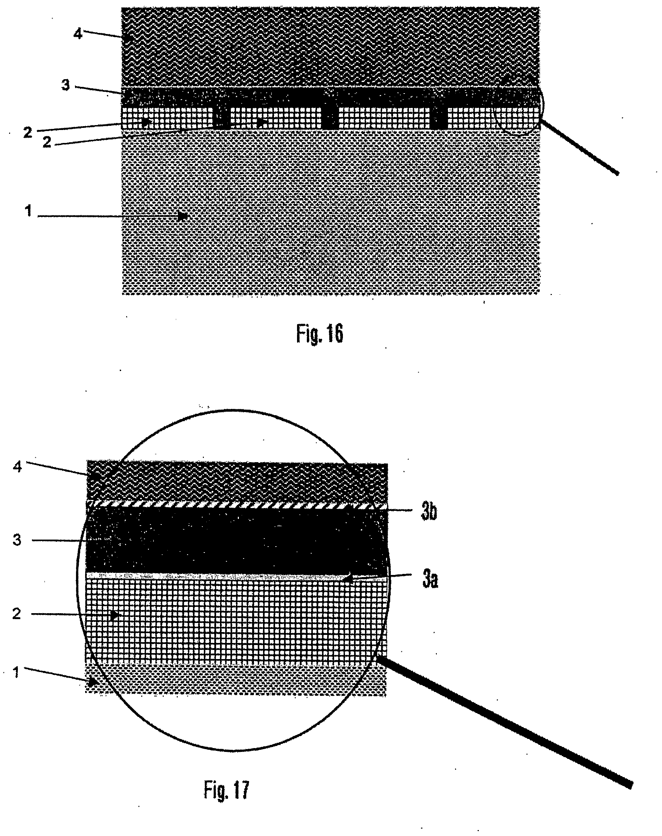

Die Erfindung wird nun anhand von Beispielen und Figuren 16 - 17 näher erläutert:
Fig. 16 stellt schematisch einen bevorzugten erfindungsgemäßen Gegenstand (Wafer mit Trägerschicht und Trennschicht) dar: Er umfasst eine Siliziumschicht 1 ohne elektronische Bauelemente, eine Schicht 2 mit elektronischen Bauelementen, die ggf. noch durch eine Passivierungsschicht geschützt ist, eine Trennschicht 3 und eine Trägerschicht 4.

Fig. 17 ist eine Detailansicht des in Fig. 16 mit einer Lupe gekennzeichneten Bereiches: Dabei werden dargestellt ein kleiner Teil der Siliziumschicht 1 ohne elektronische Bauelemente, die Schicht 2 mit elektronischen Bauelementen, die Trennschicht 3 und ein Teil der Trägerschicht 4. Innerhalb der Trennschicht 3 sind die Dehäsivzone 3a und die Adhäsivzone 3b hervorgehoben.

Zur Herstellung wird ein in den Figuren 1 und 2 abgebildeter, mit elektronischen Bauelementen versehener Siliziumwafer (aus Siliziumschicht 1 und Schicht 2 mit elektronischen Baulementen) zunächst mit einer plasmapolymeren Trennschicht 3 versehen. Diese wird dabei so aufgebaut, dass sie zur Bauteiloberfläche hin die Dehäsivzone 3a und nach außen die Adhäsivzone 3b aufweist. Der zwischen diesen Zonen liegende Bereich (vergleiche Fig. 2) stellt eine Übergangszone dar, auf die auch verzichtet werden könnte. Auf die plasmapolymere Trennschicht 3 wird danach eine dickere Trägerschicht 4 aufgetragen. Diese Trägerschicht kann beispielsweise über ein Spin-Coating-Verfahren oder mittels Lackieren aufgebracht werden. Die Ausführung der Adhäsivzone 3b muss grundsätzlich zur Trägerschicht 4 passen, um einen festeren Verbund zwischen Trägerschicht 4 und Adhäsivzone 3b als zwischen Dehäsivzone 3a und Oberfläche des Siliziumwafers (aus Schichten 1 und 2) herzustellen. Vorzugsweise wird die Trägerschicht in einer Dicke aufgetragen, die der Dünnung des Wafers in einem nachfolgenden Arbeitsschritt entspricht, um so gleiche Dickenverhältnisse entstehen zu lassen und ein gewohntes Waferhandling zu ermöglichen.

### Beispiel 3: Aufbringen einer Trennschicht als Gradientenschicht unter Einsatz eines flüssigen Precursors

Als flüssiger Precursor wurde ein lineares Polydimethylsiloxan der Kettenlänge 50 (AK 50 , Fa. Wacker Chemie) verwendet, welches mit einer Schichtdicke von 50 nm gleichmäßig auf einen zu bearbeitenden Silizium-Wafer aufgetragen wurde. Das Material AK 50 zeigte in Vorversuchen eine hohe Beständigkeit im Vakuum. Anschließend wurde der präparierte Wafer in eine Plasmapolymerisationsanlage eingebracht und unter Verwendung der in Tabelle 1 beschriebenen Parameter weiter beschichtet. Dabei wurde der Wafer während Teil 1 des Beschichtungsvorganges mit einer Hilfsvorrichtung abgedeckt, die zu Beginn von Teil 2 entfernt wurde. Die Abdeckung diente dazu, stabile Plasma- und Gasverhältnisse herzustellen, bevor der Wafer dem Plasma ausgesetzt wird. Typischerweise findet beim Start eines Plasmaprozesses nämlich eine Einschwingphase statt, die ungewünschte Einflüsse auf die Grenzfläche bzw. den flüssigen Precursor haben kann (vergleiche auch oben).

**Tabelle 1: Parameter beim Abscheiden der Trennschicht; Gesamtschichtdicke ca. 280 nm**

| | **Gas 1 [sccm]** | **Gas 2 [sccm]** | **Gas 3 [sccm]** | **Leistung [W]** | **Zeit [s]** | **Druck [mbar]** |
|---|---|---|---|---|---|---|
| **Gasart** | **HMDSO** | **O2** | **H2** | | | |
| Teil 1 | 70 | 24 | | 700 | 300 | 0,03 |
| Teil 2 | 70 | 24 | | 700 | 300 | 0,03 |
| Teil 3 | 70 | 32 | | 700 | 180 | 0,03 |
| Teil 4 | 70 | 50 | | 700 | 180 | 0,03 |
| Teil 5 | 60 | 50 | | 700 | 180 | 0,03 |
| Teil 6 | 50 | 50 | | 700 | 180 | 0,03 |
| Teil 7 | 35 | 75 | | 700 | 180 | 0,03 |
| Teil 8 | 27 | 100 | | 700 | 180 | 0,03 |
| Teil 9 | 27 | 100 | | 1500 | 180 | 0,031 |
| Teil 10 | 27 | 100 | | 2500 | 60 | 0,031 |
| Teil 11 | | 200 | 200 | 2000 | 60 | 0,04 |
| Teil 12 | | 200 | 900 | 2000 | 300 | 0,05 |
| Teil 13 | | 10000 | | 2500 | 300 | 0,22 |

Eine derartige Beschichtung konnte für 30 min auf 400 °C getempert werden, ohne die dehäsiven Eigenschaften zum beschichteten Wafer zu verlieren.

Nach dem Aufbringen einer geeigneten Trägerschicht konnte die gesamte Trennschicht vollständig von der Waferoberfläche abgezogen werden. Der Nachweis der rückstandsfreien Entfernung konnte mittels Ellipsometrie geführt werden. Mit diesem sehr empfindlichen Schichtdickenmessverfahren wurden keine Rückstände mehr detektiert. Die Abzugskräfte der Dehäsionsbeschichtung wurden durch den oben beschriebenen Tempervorgang nicht verändert. Die Trennebene war stets Waferseitig. (Bem.: Auf blanken Wafern ist dies ohne weiteres optisch nachverfolgbar, wenn die Trennschicht in einer solchen Schichtdicke aufgetragen wird, dass Interferenzfarben entstehen. Ferner kann die Randwinkelmessung auch für einen größeren lateralen Bereich zeigen, dass keine Reste der Dehäsionsschicht auf der Waferoberfläche verblieben sind.)

### Beispiel 4: Aufbringen einer dünneren Trennschicht als Gradientenschicht unter Einsatz eines flüssigen Precursors

Vorgehensweise wie in Beispiel 3, Parameter vergleiche Tabelle 2

**Tabelle 2: Parameter beim Abscheiden der Trennschicht; Gesamtschichtdicke: ca. 160 nm**

| | **Gas 1 [sccm]** | **Gas 2 [sccm]** | **Gas 3 [sccm]** | **Leistung [W]** | **Zeit [s]** | **Druck [mbar]** |
|---|---|---|---|---|---|---|
| **Gasart** | **HMDSO** | **O2** | **H2** | | | |
| Teil 1 | 70 | 24 | | 700 | 900 | 0,03 |
| Teil 2 | 70 | 24 | | 700 | 1800 | 0,03 |
| Teil 3 | | 200 | 900 | 1600 | 180 | 0,05 |
| Teil 4 | | 10000 | | 2500 | 120 | 0,22 |

## Patentansprüche

1. Wafer (1, 2; 1b, 2; 1c, 2) mit einer Trägerschicht (4) und einer zwischen der Trägerschicht (4) und dem Wafer angeordneten Trennschicht (3), wobei die Trennschicht (3) an dem Wafer (1, 2; 1b, 2; 1c, 2) haftet und an der Trägerschicht (4) fester haftet als an dem Wafer, **dadurch gekennzeichnet, dass** die Trennschicht (3) eine plasmapolymere Schicht ist.

2. Wafer (1, 2; 1b, 2; 1c, 2) nach Anspruch 1, wobei der Wafer (1, 2; 1b, 2; 1c, 2) im Wesentlichen aus gegebenenfalls dotiertem Silizium besteht.

3. Wafer (1, 2; 1b, 2; 1c, 2) nach Anspruch 1 oder 2, wobei der Wafer (1, 2; 1b, 2; 1c, 2) vorderseitig eine aktive Schicht (2) mit elektronischen Bauelementen umfasst und die Trennschicht (3) auf der Vorderseite angeordnet ist.

4. Wafer (1, 2; 1b, 2; 1c, 2) nach einem der vorangehenden Ansprüche, wobei die Trennschicht (3) eine Gradientenschicht ist oder eine an die Trägerschicht (4) angrenzende Adhäsivzone (3b) und eine an den Wafer (1, 2; 1b, 2; 1c, 2) angrenzende Dehäsivzone (3a) sowie gegebenenfalls eine Übergangszone umfasst, wobei die Adhäsiv- (3b) und die Dehäsivzone (3a) stofflich unterschiedlich zusammengesetzt sind.

5. Wafer (1, 2; 1b, 2; 1c, 2) nach einem der vorangehenden Ansprüche, wobei die Trennschicht (3) waferseitig einen vormals flüssigen Precursor, der vor dem Plasmaprozess auf den Wafer aufgetragen wurde, als integralen Bestandteil umfasst.

6. Wafer (1, 2; 1b, 2; 1c, 2) nach einem der vorangehenden Ansprüche, wobei die Trennschicht (3) an dem Wafer und der Trägerschicht (4) bei Temperaturen bis zumindest 350 °C, bevorzugt bis zumindest 380 °C, besonders bevorzugt bis zumindest 400 °C haftet.

7. Wafer (1, 2; 1b, 2; 1c, 2) nach einem der vorangehenden Ansprüche, wobei sich die Trennschicht (3) im wesentlichen rückstandsfrei von dem Wafer lösen lässt.

8. Wafer (1, 2; 1b, 2; 1c, 2) nach einem der vorangehenden Ansprüche, wobei die Trennschicht (3) und der Wafer mechanisch enthaftbar sind.

9. Wafer (1, 2; 1b, 2; 1c, 2) nach einem der vorangehenden Ansprüche, wobei die Trägerschicht (4) aus einem polymeren Material besteht.

10. Wafer (1, 2; 1b, 2; 1c, 2) nach einem der vorangehenden Ansprüche, wobei die Trennschicht (3) eine Wärmeleitfähigkeit besitzt, die die des Wafers um maximal 10 % unterschreitet.

11. Verfahren zur Herstellung eines Wafers (1, 2; 1b, 2; 1c, 2) mit einer Trägerschicht (4) und einer zwischen der Trägerschicht (4) und dem Wafer (1, 2; 1b, 2; 1c, 2) angeordneten Trennschicht (3), umfassend die Schritte:
a) Bereitstellen eines Wafers (1, 2; 1b, 2; 1c, 2),
b) Versehen des Wafers (1, 2; 1b, 2; 1c, 2) mit einer Trennschicht (3), so dass diese an dem Wafer (1, 2; 1b, 2; 1c, 2) haftet,
c) Aufbringen einer Trägerschicht (4) auf die Trennschicht (3), so dass die Trennschicht (3) an der Trägerschicht (4) fester haftet als an dem Wafer (1, 2; 1b, 2; 1c, 2), **dadurch gekennzeichnet, dass** die Trennschicht eine plasmapolymere Schicht ist.

12. Verfahren nach Anspruch 11, wobei der Wafer (1, 2; 1b, 2; 1c, 2) vorderseitig eine aktive Schicht mit elektronischen Bauelementen umfasst und die Trennschicht (3) an der Vorderseite angeordnet wird.

13. Verfahren nach Anspruch 11 oder 12, wobei in Schritt b) die Trennschicht (3) auf den Wafer (1, 2; 1b, 2; 1c, 2) abgeschieden wird, wobei die Abscheidungsbedingungen zeitlich variiert werden, so dass die erzeugte Trennschicht (3) eine Gradientenschicht ist oder eine Adhäsivzone (3b) zum Aufbringen der Trägerschicht (4) und eine an den Wafer (1, 2; 1b, 2; 1c, 2) angrenzende Dehäsivzone (3a) sowie gegebenenfalls eine Übergangszone umfasst.

14. Verfahren nach einem der Ansprüche 11 bis 13, wobei der Wafer (1, 2; 1b, 2; 1c, 2) vor Schritt b) mit einem flüssigen Precursor benetzt wird.

15. Verfahren nach Anspruch 14, wobei der flüssige Precursor eine trennaktive Substanz ist.

16. Verfahren nach Anspruch 14 oder 15, wobei der flüssige Precursor mittels Tauchens, Spühens oder eines Spin-Coating-Verfahrens auf den Wafer (1, 2; 1b, 2; 1c, 2) aufgebracht wird.

17. Verfahren nach einem der Ansprüche 14 bis 16, wobei der Schritt b) so durchgeführt wird, dass der flüssige Precursor vernetzt und integraler Bestandteil der Trennschicht (3) wird.

18. Verfahren zum Abdünnen eines Wafers (1, 2), umfassend die folgenden Schritte:
- Herstellen eines Wafers (1, 2) mit einer Trägerschicht (4) und einer zwischen der Trägerschicht (4) und dem Wafer (1, 2) angeordneten Trennschicht (3) nach einem Verfahren gemäß einem der Ansprüche 11 bis 17, wobei in Schritt a) ein zu abdünnender Wafer (1, 2) bereitgestellt wird und
- Abdünnen des Wafers (1, 2) von seiner Rückseite her.

19. Verfahren zum Rückseitenmetallisieren eines Wafers (1, 2; 1b, 2; 1c, 2), umfassend die folgenden Schritte:
- Herstellen und gegebenenfalls Abdünnen eines Wafers (1, 2; 1b, 2; 1c, 2) mit einer Trägerschicht (4) und einer zwischen der Trägerschicht (4) und dem Wafer (1, 2; 1b, 2; 1c, 2) angeordneten Trennschicht (3) nach einem Verfahren gemäß einem der Ansprüche 11 bis 18 und
- Aufbringen einer Metallschicht auf die Rückseite des Wafers (1, 2; 1b, 2; 1c, 2).

20. Verfahren nach Anspruch 18 oder 19, wobei die Trenn- (3) und die Trägerschicht (4) nach dem Abdünnen oder dem Rückseitenmetallisieren wieder von dem Wafer (1b, 2; 1c, 2) entfernt wird.

21. Verfahren nach einem der Ansprüche 11 bis 20, wobei in Schritt (a) ein zur Trennung in einzelne Elemente vorbereiteter Wafer (1, 2; 1b, 2; 1c, 2) bereitgestellt wird.

22. Verfahren nach Anspruch 21, wobei durch das Abdünnen oder das Entfernen der Trenn- (3) und der Trägerschicht (4) eine Trennung des Wafers (1, 2; 1b, 2; 1c, 2) - gegebenenfalls mit Ausnahme der Rückseitenmetallisierung - in einzelne Elemente bewirkt wird.

## Claims

1. Wafer (1, 2; 1b, 2; 1c, 2) comprising a carrier layer (4) and a separating layer (3) arranged between the carrier layer (4) and the wafer, wherein the separating layer (3) adheres to the wafer (1, 2; 1b, 2; 1c, 2) and adheres to the carrier layer (4) more firmly than to the wafer, **characterized in that** the separating layer (3) is a plasma-polymeric layer.

2. Wafer (1, 2; 1b, 2; 1c, 2) according to Claim 1, wherein the wafer (1, 2; 1b, 2; 1c, 2) substantially consists of possibly doped silicon.

3. Wafer (1, 2; 1b, 2; 1c, 2) according to Claim 1 or 2, wherein the wafer (1, 2; 1b, 2; 1c, 2) comprises on the front side an active layer (2) with electronic components and the separating layer (3) is arranged on the front side.

4. Wafer (1, 2; 1b, 2; 1c, 2) according to any of the preceding claims, wherein the separating layer (3) is a gradient layer or comprises an adhesive zone (3b) adjoining the carrier layer (4), and an abhesive zone (3a) adjoining the wafer (1, 2; 1b, 2; 1c, 2), and if appropriate a transition zone, wherein the adhesive zone (3b) and the abhesive zone (3a) have materially different compositions.

5. Wafer (1, 2; 1b, 2; 1c, 2) according to any of the preceding claims, wherein the separating layer (3) comprises on the wafer side as an integral constituent a formerly liquid precursor that was applied to the wafer before the plasma process.

6. Wafer (1, 2; 1b, 2; 1c, 2) according to any of the preceding claims, wherein the separating layer (3) adheres to the wafer and the carrier layer (4) at temperatures of up to at least 350°C, preferably up to at least 380°C, particularly preferably up to at least 400°C.

7. Wafer (1, 2; 1b, 2; 1c, 2) according to any of the preceding claims, wherein the separating layer (3) can be stripped from the wafer substantially without any residues.

8. Wafer (1, 2; 1b, 2; 1c, 2) according to any of the preceding claims, wherein the separating layer (3) and the wafer are mechanically releasable.

9. Wafer (1, 2; 1b, 2; 1c, 2) according to any of the preceding claims, wherein the carrier layer (4) consists of a polymer material.

10. Wafer (1, 2; 1b, 2; 1c, 2) according to any of the preceding claims, wherein the separating layer (3) has a thermal conductivity which falls below that of the wafer by a maximum of 10%.

11. Method for producing a wafer (1, 2; 1b, 2; 1c, 2) comprising a carrier layer (4) and a separating layer (3) arranged between the carrier layer (4) and the wafer (1, 2; 1b, 2; 1c, 2), comprising the following steps:
a) providing a wafer (1, 2; 1b, 2; 1c, 2),
b) providing the wafer (1, 2; 1b, 2; 1c, 2) with a separating layer (3), such that the latter adheres to the wafer (1, 2; 1b, 2; 1c, 2),
c) applying a carrier layer (4) to the separating layer (3), such that the separating layer (3) adheres to the carrier layer (4) more firmly than to the wafer (1, 2; 1b, 2; 1c, 2), **characterized in that** the separating layer is a plasma-polymeric layer.

12. Method according to Claim 11, wherein the wafer (1, 2; 1b, 2; 1c, 2) comprises on the front side an active layer with electronic components and the separating layer (3) is arranged at the front side.

13. Method according to Claim 11 or 12, wherein in step b) the separating layer (3) is deposited onto the wafer (1, 2; 1b, 2; 1c, 2), wherein the deposition conditions are varied over time, such that the separating layer (3) produced is a gradient layer or comprises an adhesive zone (3b) for applying the carrier layer (4), and an abhesive zone (3a) adjoining the wafer (1, 2; 1b, 2; 1c, 2), and if appropriate a transition zone.

14. Method according to any of Claims 11 to 13, wherein the wafer (1, 2; 1b, 2; 1c, 2) is wetted with a liquid precursor before step b).

15. Method according to Claim 14, wherein the liquid precursor is a separation-active substance.

16. Method according to Claim 14 or 15, wherein the liquid precursor is applied to the wafer (1, 2; 1b, 2; 1c, 2) by means of dipping, spraying or a spin-coating method.

17. Method according to any of Claims 14 to 16, wherein step b) is carried out such that the liquid precursor is crosslinked and becomes an integral constituent of the separating layer (3).

18. Method for thinning a wafer (1, 2), comprising the following steps:
- producing a wafer (1, 2) comprising a carrier layer (4) and a separating layer (3) arranged between the carrier layer (4) and the wafer (1, 2) according to a method according to any of Claims 11 to 17, wherein in step a) a wafer (1, 2) to be thinned is provided, and
- thinning the wafer (1, 2) from the rear side thereof.

19. Method for the rear-side metallizing of a wafer (1, 2; 1b, 2; 1c, 2), comprising the following steps:
- producing and if appropriate thinning a wafer (1, 2; 1b, 2; 1c, 2) comprising a carrier layer (4) and a separating layer (3) arranged between the carrier layer (4) and the wafer (1, 2; 1b, 2; 1c, 2) according to a method according to any of Claims 11 to 18, and
- applying a metal layer to the rear side of the wafer (1, 2; 1b, 2; 1c, 2).

20. Method according to Claim 18 or 19, wherein the separating layer (3) and the carrier layer (4) are removed again from the wafer (1b, 2; 1c, 2) after the thinning or the rear-side metallizing.

21. Method according to any of Claims 11 to 20, wherein a wafer (1, 2; 1b, 2; 1c, 2) prepared for separation into individual elements is provided in step (a).

22. Method according to Claim 21, wherein a separation of the wafer (1, 2; 1b, 2; 1c, 2) - if appropriate with the exception of the rear-side metallization - into individual elements is effected by the thinning or the removing of the separating layer (3) and the carrier layer (4).

## Revendications

1. Tranche (1, 2 ; 1b, 2 ; 1c, 2) avec une couche de support (4) et une couche de séparation (3) disposée entre la couche de support (4) et la tranche, dans laquelle la couche de séparation (3) adhère au niveau de la tranche (1, 2 ; 1b, 2 ; 1c, 2) et adhère plus solidement au niveau de la couche de support (4) qu'au niveau de la tranche, **caractérisée en ce que** la couche de séparation (3) est une couche en polymère plasma.

2. Tranche (1, 2 ; 1b, 2 ; 1c, 2) selon la revendication 1, dans laquelle la tranche (1, 2 ; 1b, 2 ; 1c, 2) est constituée sensiblement d'un silicium éventuellement dopé.

3. Tranche (1, 2 ; 1b, 2 ; 1c, 2) selon la revendication 1 ou 2, dans laquelle la tranche (1, 2 ; 1b, 2 ; 1c, 2) comprend, côté avant, une couche active (2) avec des composants électroniques et la couche de séparation (3) est disposée sur le côté avant.

4. Tranche (1, 2 ; 1b, 2 ; 1c, 2) selon l'une quelconque des revendications précédentes, dans laquelle la couche de séparation (3) est une couche à gradient ou comprend une zone adhésive (3b) et une zone non adhésive (3a) contiguë à la tranche (1, 2 ; 1b, 2 ; 1c, 2) ainsi qu'éventuellement une zone de transition, dans laquelle la zone adhésive (3b) et la zone non adhésive (3a) sont composées de matières différentes.

5. Tranche (1, 2 ; 1b, 2 ; 1c, 2) selon l'une quelconque des revendications précédentes, dans laquelle la couche de séparation (3) comprend, en tant que constituant intégral côté tranche, un précurseur précédemment liquide, qui a été appliqué sur la tranche avant le processus plasma.

6. Tranche (1, 2 ; 1b, 2 ; 1c, 2) selon l'une quelconque des revendications précédentes, dans laquelle la couche de séparation (3) adhère au niveau de la tranche et de la couche de support (4) à des températures allant au moins jusqu'à 350 °C, de manière préférée allant jusqu'à au moins 380 °C, de manière particulièrement préférée allant jusqu'à au moins 400 °C.

7. Tranche (1, 2 ; 1b, 2 ; 1c, 2) selon l'une quelconque des revendications précédentes, dans laquelle la couche de séparation (3) peut se détacher de la tranche sensiblement sans laisser de résidus.

8. Tranche (1, 2 ; 1b, 2 ; 1c, 2) selon l'une quelconque des revendications précédentes, dans laquelle la couche de séparation (3) et la tranche peuvent être démoulées mécaniquement.

9. Tranche (1, 2 ; 1b, 2 ; 1c, 2) selon l'une quelconque des revendications précédentes, dans laquelle la couche de support (4) est constituée d'un matériau polymère.

10. Tranche (1, 2 ; 1b, 2 ; 1c, 2) selon l'une quelconque des revendications précédentes, dans laquelle la couche de séparation (3) possède une conductivité thermique, qui est inférieure à celle de la tranche de 10 % au maximum.

11. Procédé servant à fabriquer une tranche (1, 2 ; 1b, 2 ; 1c, 2) avec une couche de support (4) et une couche de séparation (3) disposée entre la couche de support (4) et la tranche (1, 2 ; 1b, 2 ; 1c, 2), comprenant les étapes consistant à :
a) fournir une tranche (1, 2 ; 1b, 2 ; 1c, 2),
b) pourvoir la tranche (1, 2 ; 1b, 2 ; 1c, 2) d'une couche de séparation (3) de sorte que celle-ci adhère au niveau de la tranche (1, 2 ; 1b, 2 ; 1c, 2),
c) appliquer une couche de support (4) sur la couche de séparation (3) de sorte que la couche de séparation (3) adhère plus solidement au niveau de la couche de support (4) qu'au niveau de la tranche (1, 2 ; 1b, 2 ; 1c, 2), **caractérisé en ce que** la couche de séparation est une couche polymère plasma.

12. Procédé selon la revendication 11, dans lequel la tranche (1, 2 ; 1b, 2 ; 1c, 2) comprend, côté avant, une couche active avec des composants électroniques et la couche de séparation (3) est disposée au niveau du côté avant.

13. Procédé selon la revendication 11 ou 12, dans lequel, à l'étape b), la couche de séparation (3) sur la tranche (1, 2 ; 1b, 2 ; 1c, 2) est séparée, dans lequel les conditions de séparation varient dans le temps de sorte que la couche de séparation (3) produite est une couche à gradient ou comprend une zone adhésive (3b) servant à appliquer la couche de support (4) et une zone non adhésive (3a) contiguë à la tranche (1, 2 ; 1b, 2 ; 1c, 2) ainsi qu'éventuellement une zone de transition.

14. Procédé selon l'une quelconque des revendications 11 à 13, dans lequel la tranche (1, 2 ; 1b, 2 ; 1c, 2) est humidifiée avant l'étape b) avec un précurseur liquide.

15. Procédé selon la revendication 14, dans lequel le précurseur liquide est une substance de séparation active.

16. Procédé selon la revendication 14 ou 15, dans lequel le précurseur liquide est appliqué sur la tranche (1, 2 ; 1b, 2 ; 1c, 2) au moyen d'une immersion, d'une aspersion ou d'un procédé de revêtement par centrifugation.

17. Procédé selon l'une quelconque des revendications 14 à 16, dans lequel l'étape b) est effectuée de telle sorte que le précurseur liquide est réticulé et devient partie intégrante de la couche de séparation (3).

18. Procédé servant à amincir une tranche (1, 2), comprenant les étapes suivantes consistant à :
- fabriquer une tranche (1, 2) avec une couche de support (4) et une couche de séparation (3) disposée entre la couche de support (4) et la tranche (1, 2) selon un procédé selon l'une quelconque des revendications 11 à 17, dans lequel, à l'étape a), une tranche (1, 2) à amincir est fournie, et
- amincir la tranche (1, 2) depuis son côté arrière.

19. Procédé servant à métalliser le côté arrière d'une tranche (1, 2 ; 1b, 2 ; le, 2), comprenant les étapes suivantes consistant à :
- fabriquer et éventuellement amincir une tranche (1, 2 ; 1b, 2 ; le, 2) avec une couche de support (4) et une couche de séparation (3) disposée entre la couche de support (4) et la tranche (1, 2 ; 1b, 2 ; le, 2) selon un procédé selon l'une quelconque des revendications 11 à 18 et
- appliquer une couche de métal sur le côté arrière de la tranche (1, 2 ; 1b, 2 ; le, 2).

20. Procédé selon la revendication 18 ou 19, dans lequel la couche de séparation (3) et la couche de support (4) sont retirées à nouveau de la tranche (1b, 2 ; le, 2) après l'amincissement ou la métallisation du côté arrière.

21. Procédé selon l'une quelconque des revendications 11 à 20, dans lequel, à l'étape a), une tranche (1, 2 ; 1b, 2 ; le, 2) préparée aux fins de la séparation en divers éléments est fournie.

22. Procédé selon la revendication 21, dans lequel une séparation de la tranche (1, 2 ; 1b, 2 ; le, 2) - éventuellement à l'exception de la métallisation du côté arrière - en divers éléments est provoquée par l'amincissement ou le retrait de la couche de séparation (3) et de la couche de support (4).
